# EUROPEAN PATENT SPECIFICATION

(11) **EP 4 456 123 B1**
(45) Date of publication and mention of the grant of the patent: **26.11.2025**
(21) Application number: 21969842.0
(22) Date of filing: 31.12.2021
(51) Int. Cl.: H01L 21/768, H01L 23/532, H01L 23/485, H01L 23/522

(54) **CHIP, PREPARATION METHOD THEREFOR AND ELECTRONIC DEVICE**
CHIP, HERSTELLUNGSVERFAHREN DAFÜR UND ELEKTRONISCHE VORRICHTUNG
PUCE, SON PROCÉDÉ DE PRÉPARATION, ET DISPOSITIF ÉLECTRONIQUE

(43) Date of publication of application: 30.10.2024
(73) Proprietor: Huawei Technologies Co., Ltd., Shenzhen, Guangdong 518129 (CN)
(72) Inventor: ZHANG, Kehao, Shenzhen, Guangdong 518129 (CN); YE, Minghui, Shenzhen, Guangdong 518129 (CN); LIN, Jun, Shenzhen, Guangdong 518129 (CN)
(74) Representative: Epping - Hermann - Fischer
(86) International application number: PCT/CN2021/144027
(87) International publication number: WO 2023/123499

(56) References cited:
- WO-A1-2006/057236
- CN-A- 109 148 363
- JP-A- 2011 009 642
- US-A1- 2006 019 493
- US-A1- 2008 083 989
- US-B1- 6 319 819

## Description

### TECHNICAL FIELD

This application relates to the field of semiconductor technologies, and in particular, to a chip, a chip preparation method, and an electronic device.

### BACKGROUND

Manufacturing of a chip needs to go through a series of processes, where the processes include different process steps such as etching, lithography, and the like. A conventional manufacturing process includes a plurality of steps. The manufacturing process usually includes two main types of processes: a front end of line (front end of line, FEOL) and a back end of line (back end of line, BEOL). The front end of line mainly includes formation of an electronic element such as a transistor, a capacitor, a resistor, an inductor, or the like, and the back end of line mainly includes formation of a wiring layer above the electronic element.

Many process steps such as a chemical vapor deposition (chemical vapor deposition, CVD) process, a lithography (lithography) process, an etching (etch) process, a physical vapor deposition (physical vapor deposition, PVD) process, a chemical mechanical polishing (chemical mechanical polish, CMP) process, and the like are usually used when a structure of the back end of line is formed. The process steps are correlated. In other words, adverse impact of a previous step usually causes a chain reaction in a subsequent step. Consequently, a feature size of the chip finally cannot meet a preset requirement, and chip reliability is reduced.

Document JP 2011-009642 A provides a semiconductor device that achieves good adhesion with respect to a barrier metal insulating film and Cu, and prevents diffusion of Cu at the same time, and a method of manufacturing the same. A seal insulating film is formed on a sidewall of a recess in an insulating film, and a Cu-based buried electrode is formed through a barrier layer of a three-layer structure including a first conductive barrier layer having an superior adhesion with the seal insulating film, a second conductive barrier layer having a high Cu diffusion preventing capability and a third conductive barrier layer having an superior adhesion with the Cu-based buried electrode, which are arranged sequentially inside the seal insulating film.

Document US 2008/083989 A1 discloses a semiconductor device that includes insulation films formed over a silicon substrate, a buried wire formed in the insulation films, and a barrier metal film formed between each of the insulation films and the buried wire. The barrier metal film is formed of a metal oxide film, a transition layer and a metal film stacked in this order in the direction from a side of the barrier metal film at which the insulation films exist to a side thereof at which the buried wire exists. The transition layer is formed of a single atomic layer having substantially an intermediate composition between respective compositions of the metal oxide film and the metal film.

### SUMMARY

Embodiments of this application provide a chip, a chip preparation method, and an electronic device, to resolve a problem of how to improve chip reliability.

To achieve the foregoing objective, this application uses the following technical solutions. The present invention is defined by the attached set of claims. Embodiments and aspects which are not covered by the invention should be considered as examples useful for understanding the invention.

A first aspect of embodiments of this application provides a chip (or referred to as an integrated circuit device) preparation method. The method includes: forming a first inter-metal dielectric layer having a first opening and a first wiring layer on a substrate on which an electronic element (for example, a transistor, a capacitor, a resistor, or the like), where the first wiring layer includes a first conductive pattern, and the first conductive pattern passes through the first opening and is coupled to a conductive portion of the electronic element (where the coupling may be direct or indirect coupling), and a material of the first conductive pattern includes first metal; forming a second inter-metal dielectric layer having a second opening on the first inter-metal dielectric layer, where the second opening exposes the first conductive pattern, the first metal on a top surface of the first conductive pattern is oxidized into oxide of the first metal, and at least a part of second metal in a portion that is of a first metal film and that is in contact with the first conductive pattern is oxidized into oxide of the second metal; forming the first metal film on the first inter-metal dielectric layer, where the first metal film is in contact with the top surface of the first conductive pattern through the second opening, a material of the first metal film includes the second metal, the oxide of the second metal is a conductive material, and reactivity of the second metal is greater than reactivity of the first metal; enabling the second metal to react with the oxide of the first metal, to reduce at least a part of the oxide of the first metal on the top surface of the first conductive pattern to the first metal; forming a second metal film on the first metal film, where the second metal film fills the second opening and is coupled to the first conductive pattern; and patterning the first metal film and the second metal film, to form a third conductive pattern and a second conductive pattern, so that a second wiring layer is formed, where the third conductive pattern includes a first portion disposed between the second conductive pattern and the first conductive pattern, and a material of the first portion includes the oxide of the second metal.

According to the chip preparation method provided in this embodiment of this application, because the reactivity of the second metal in the first metal film is greater than the reactivity of the first metal in the first conductive pattern, an oxidation-reduction reaction occurs between the second metal and the oxide of the first metal in a high-temperature annealing environment, and the oxide of the first metal on the top surface of the first conductive pattern is reduced to a first metal element. This reduces resistance of the first conductive pattern. A plasma pre-cleaning step is replaced with oxidation-reduction, so that damage (or referred to as a kink) to a second ULK layer caused by the plasma pre-cleaning step can be avoided, to improve chip reliability. In addition, the reactivity of the second metal in the first metal film is greater than the reactivity of the first metal in the first conductive pattern, so that resistivity of the oxide of the second metal is (about > four orders of magnitude) less than resistivity of the oxide of the first metal. For a finally formed chip, a material of the top surface of the first conductive pattern is the first metal element. When the oxide of the second metal exists between the first conductive pattern and the second conductive pattern, connection resistance between the first conductive pattern and the second conductive pattern is less than connection resistance between the first conductive pattern and the second conductive pattern when the oxide of the first metal exists between the first conductive pattern and the second conductive pattern. The chip formed through integration has lower resistivity.

In a possible implementation, the forming the first metal film on the first inter-metal dielectric layer includes: forming the first metal film on the first inter-metal dielectric layer by using an atomic layer deposition process. Thicknesses of all portions of the first metal film are equal, and a surface of the first metal film is planar. The first metal film is formed by using the atomic layer deposition process, and film thicknesses of all portions of the finally formed third conductive pattern are equal. A structure is simple and easy to design.

In a possible implementation, the first metal film is formed on the first inter-metal dielectric layer by using a physical vapor deposition process. Thicknesses of all portions of the first metal film are equal, and a surface of the first metal film is a curved surface. The first metal film is formed by using the physical vapor deposition process, and the finally formed third conductive pattern is thin. Therefore, an area occupied by the third conductive pattern in the second opening is reduced, an area occupied by the second conductive pattern in the second opening is increased, and a conductive effect of the second wiring layer is improved.

In a possible implementation, the first metal film is formed on the first inter-metal dielectric layer by using a physical vapor deposition process at a very high frequency. A thickness of a portion that is of the first metal film and that is in contact with the top surface of the first conductive pattern is greater than a thickness of a portion that is of the first metal film and that is in contact with an inner wall of the second opening. In this way, in the finally formed third conductive pattern, a thickness of the first portion that is in contact with the top surface of the first conductive pattern is greater than a thickness of a second portion that is in contact with the inner wall of the second opening. The thickness of the second portion may be reduced, so that impact of the thickness of the second portion on an area occupied by the second conductive pattern in the second opening is reduced. In addition, the thickness of the first portion may be increased, so that the second metal in the first portion reduces the oxide of the first metal in the first conductive pattern to the first metal element as much as possible, to improve resistivity of the chip.

In a possible implementation, the enabling the second metal is to react with the oxide of the first metal includes: performing annealing on the first conductive pattern and the first metal film at a temperature of 300°C to 400°C, so that the oxidation-reduction reaction occurs between the second metal in the first metal film and the oxide of the first metal on the top surface of the first conductive pattern. A method for reducing the oxide of the first metal without damaging another film layer is provided.

In a possible implementation, after the second wiring layer is formed, the chip preparation method further includes: performing annealing on, at the temperature of 300°C to 400°C in a gas environment including hydrogen, the substrate on which the first wiring layer and the second wiring layer are formed. Second metal with high electronegativity has a catalytic capability of decomposing hydrogen at a high temperature (300°C) to form a hydrogen free radical (H*). The annealing is performed at the temperature of 300°C to 400°C in the gas environment including the hydrogen (for example, a mixture of the hydrogen and nitrogen), and in this case, the second metal may catalyze decomposition of H₂ into H*, and the H* has extremely strong reducibility. When the oxide of the first metal in the first conductive pattern is not completely reduced, the H* can further reduce the oxide of the first metal (for example, copper oxide). This further reduces resistance of the chip.

A second aspect of embodiments of this application provides a chip. Alternatively, the chip is referred to as an integrated circuit device. The chip includes a substrate, an electronic element disposed on the substrate, a first wiring layer, and a second wiring layer. An electronic element such as a transistor, a capacitor, a resistor, an inductor, or the like in the chip includes a conductive portion. The first wiring layer is disposed on a side that is of the electronic element and that is away from the substrate. Another film layer may be disposed between the first wiring layer and the electronic element, or the first wiring layer may be directly disposed on a surface of the electronic element. The first wiring layer includes a first conductive pattern, and the first conductive pattern is coupled to the conductive portion. The second wiring layer is disposed on a surface of the first wiring layer. The second wiring layer includes a second conductive pattern and a third conductive pattern. The third conductive pattern includes a first portion disposed between the second conductive pattern and the first conductive pattern. The first portion is in contact with the first conductive pattern and is coupled to the second conductive pattern. A material of a top surface that is of the first conductive pattern and that is in contact with the third conductive pattern includes a first metal element. A material of the first portion includes oxide of second metal, the oxide of the second metal is a conductive material, and reactivity of the second metal is greater than reactivity of the first metal.

According to the chip provided in this embodiment of this application, the reactivity of the second metal is greater than the reactivity of the first metal, so that resistivity of the oxide of the second metal is (about > four orders of magnitude) less than resistivity of oxide of the first metal. Therefore, when the oxide of the second metal exists between the first conductive pattern and the second conductive pattern, connection resistance between the first conductive pattern and the second conductive pattern is less than connection resistance between the first conductive pattern and the second conductive pattern when the oxide of the first metal exists between the first conductive pattern and the second conductive pattern. The chip formed through integration has lower resistivity. In addition, when a chip is prepared according to the chip preparation method provided in embodiments of this application, because the reactivity of the second metal in a first metal film is greater than the reactivity of the first metal in the first conductive pattern, an oxidation-reduction reaction occurs between the second metal and the oxide of the first metal in a high-temperature annealing environment, and the oxide of the first metal on the top surface of the first conductive pattern is reduced to the first metal element. This reduces resistance of the first conductive pattern. A plasma pre-cleaning step is replaced with oxidation-reduction, so that damage (or referred to as a kink) to a second ULK layer caused by the plasma pre-cleaning step can be avoided, to improve chip reliability.

The third conductive pattern further includes a second portion disposed on a side surface of the second conductive pattern. The third conductive pattern including the first portion and the second portion has a simple process and is easy to prepare.

A thickness of the first portion is greater than a thickness of the second portion. The thickness of the first portion of the third conductive pattern is greater than the thickness of the second portion. The thickness of the second portion may be reduced, so that impact of the thickness of the second portion on an area occupied by the second conductive pattern in the second opening is reduced. In addition, the thickness of the first portion may be increased, so that the second metal in the first portion reduces the oxide of the first metal in the first conductive pattern to the first metal element as much as possible, to improve resistivity of the chip.

In a possible implementation, a material of the second portion includes the second metal. In this way, the second portion and the first portion may be formed in a same process, and the process is simple.

In a possible implementation, the material of the first portion includes the second metal. It is unnecessary for all of the second metal in the first portion to undergo the reduction reaction with the oxide of the first metal.

In a possible implementation, a material of the first conductive pattern is the first metal. All of the oxide of the first metal in the first conductive pattern is reduced to the first metal, so that a conductive effect of the first conductive pattern can be improved.

In a possible implementation, the first wiring layer further includes a fourth conductive pattern, and the fourth conductive pattern covers at least a bottom surface of the first conductive pattern. The first wiring layer may be a first layer of a wiring layer, or may be an immediate layer of a wiring layer, and is applicable to various solutions.

In a possible implementation, the electronic element includes at least one of the transistor, the capacitor, the resistor, and the inductor. Alternatively, the electronic element included in the chip in this application may be any electronic element, and has a wide application scope.

In a possible implementation, the first wiring layer further includes a first diffusion barrier pattern, and the first diffusion barrier pattern covers a side surface and the bottom surface of the first conductive pattern. The first diffusion barrier pattern is disposed on an outer side of the first conductive pattern, so that metal ion diffusion in the first conductive pattern can be effectively prevented, electron migration can be resisted, and a resistor-capacitor delay of the chip can be reduced.

In a possible implementation, the second wiring layer further includes a second diffusion barrier pattern, and the second diffusion barrier pattern is disposed between the second conductive pattern and the third conductive pattern and covers a bottom surface and the side surface of the second conductive pattern. The second diffusion barrier pattern is disposed on an outer side of the second conductive pattern, so that metal ion diffusion in the second conductive pattern can be effectively prevented, the electron migration can be resisted, and the resistor-capacitor delay of the chip can be reduced.

In a possible implementation, the chip further includes a first inter-metal dielectric layer, and the first inter-metal dielectric layer is disposed on the electronic element and wraps the side surface of the first conductive pattern.

In a possible implementation, the chip further includes a second inter-metal dielectric layer, and the second inter-metal dielectric layer is disposed on a surface of the first inter-metal dielectric layer and wraps the side surface of the second conductive pattern and a side surface of the third conductive pattern.

A third aspect of embodiments of this application provides an electronic device. The electronic device includes a circuit board and the chip according to any one of the possible implementations of the second aspect. The chip is disposed on the circuit board.

The electronic device provided in the third aspect of embodiments of this application includes the chip according to any one of the possible implementations of the second aspect, and beneficial effects of the electronic device are the same as beneficial effects of the chip. Details are not described herein again.

### BRIEF DESCRIPTION OF DRAWINGS

FIG. 1A is a diagram of a framework of an electronic device according to an embodiment of this application;
FIG. 1B is a diagram of an equivalent circuit of a chip according to an embodiment of this application;
FIG. 1C to FIG. 1E each are a diagram of a chip preparation process according to an embodiment of this application;
FIG. 2A is a diagram of a pre-cleaning process according to an embodiment of this application;
FIG. 2B is a diagram of holes on a chip according to an embodiment of this application;
FIG. 3 is a diagram of a chip preparation procedure according to an embodiment of this application;
FIG. 4 to FIG. 8A each are a diagram of a preparation process of a part of a chip according to an embodiment of this application;
FIG. 8B is a diagram of a structure of a chip in a chip preparation process according to an embodiment of this application;
FIG. 9A is a diagram of a structure of a chip according to an embodiment of this application;
FIG. 9B is a diagram of a structure of another chip according to an embodiment of this application;
FIG. 9C-1 and FIG. 9C-2 to FIG. 9E each are a diagram of a preparation process of a part of a chip according to an embodiment of this application; and

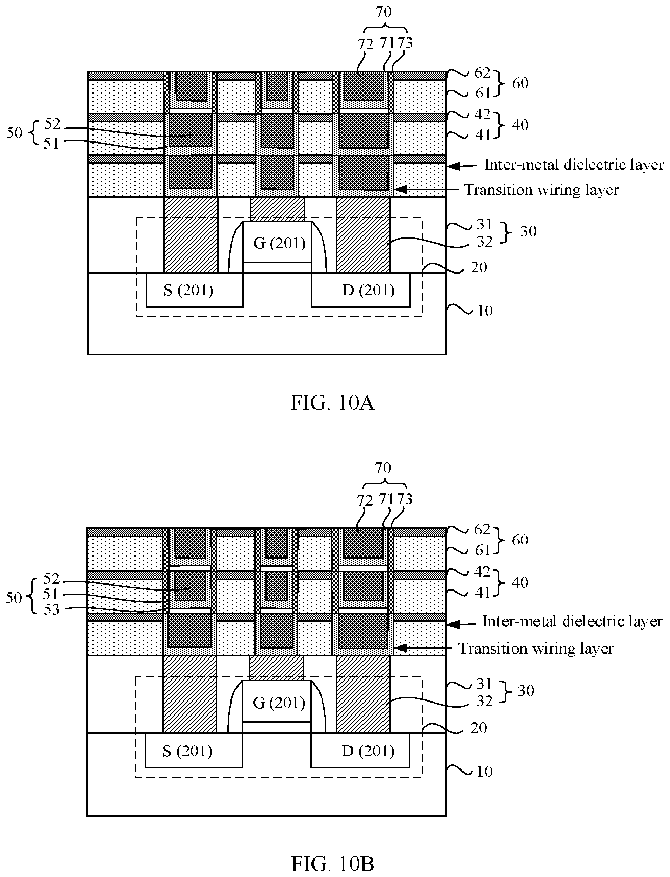

FIG. 10A to FIG. 10D each are a diagram of a structure of still another chip according to an embodiment of this application.

Reference numerals:
1: electronic device; 2: display module; 3: middle frame; 4: housing; 5: cover plate; 10: substrate; 20: electronic element; 201: conductive portion; 21: first switching transistor; 22: pull-up circuit; 23: pull-down circuit; 30: intermediate layer; 31: intermediate dielectric layer; 301: opening; 32: transfer pattern; 40: first inter-metal dielectric layer; 401: first opening; 41: first ULK layer; 410: first ULK film; 42: first dielectric layer; 420: first dielectric film; 50: first wiring layer; 51: first diffusion barrier pattern; 510: first diffusion barrier film; 52: first conductive pattern; 520: third metal film; 60: second inter-metal dielectric layer; 601: second opening; 61: second UKL layer; 610: second ULK film; 62: second dielectric layer; 620: second dielectric film; 70: second wiring layer; 71: second diffusion barrier layer; 710: second diffusion barrier film; 72: second conductive pattern; 720: second metal film; 73: third conductive pattern; 731: first portion; 732: second portion; 730: first metal film.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first", "second", and the like in embodiments of this application are merely used for ease of description, and shall not be understood as an indication or implication of relative importance or implicit indication of a quantity of indicated technical features. Therefore, a feature limited by "first", "second", or the like may explicitly or implicitly include one or more features. In descriptions of this application, unless otherwise stated, "a plurality of" means two or more than two.

In embodiments of this application, "up", "down", "left", and "right" are not limited to definitions relative to directions in which components are schematically placed in the accompanying drawings. It should be understood that these directional terms may be relative concepts used for relative description and clarification, and may change correspondingly based on a change of a direction in which a component in an accompanying drawing is placed.

In embodiments of this application, unless otherwise specified in the context, in the entire specification and claims, a term "include" is interpreted as "open and inclusive", that is, "include, but not limited to". In the descriptions of the specification, terms such as "an embodiment", "some embodiments", "example embodiments", "examples", "some examples", and the like are intended to indicate that particular features, structures, materials, or characteristics related to embodiments or examples are included in at least one embodiment or example of the present disclosure. The foregoing schematic representations of the terms do not necessarily refer to a same embodiment or example. In addition, the particular features, structures, materials, or characteristics may be included in any one or more embodiments or examples in any appropriate manner.

In the descriptions of some embodiments, expressions of "coupled" and extensions thereof may be used. For example, in the descriptions of some embodiments, the term "coupled" may indicate that two or more components are in direct physical contact or electrical contact. However, the term "coupled" may also indicate that two or more components are not in direct contact with each other, but still collaborate or interact with each other. Embodiments disclosed herein are not necessarily limited to content of the specification.

A term "and/or" in embodiments of this application describes only an association relationship for describing associated objects and represents that three relationships may exist. For example, A and/or B may represent the following three cases: Only A exists, both A and B exist, and only B exists. In addition, a character "/" in the specification generally indicates an "or" relationship between the associated objects.

In embodiments of this application, an example implementation is described with reference to a sectional view and/or a plane diagram and/or an equivalent circuit diagram that are/is used as idealized example accompanying drawings. In the accompanying drawings, for clarity, thicknesses of layers and regions are enlarged. Therefore, a change in a shape in the accompanying drawings due to, for example, manufacturing techniques and/or tolerances may be envisaged. Therefore, example implementations should not be construed as being limited to a shape of a region shown in the specification, but rather include shape deviations due to, for example, manufacturing. For example, an etching region shown as a rectangle typically has a bending feature. Therefore, the regions shown in the accompanying drawings are essentially examples, and their shapes are not intended to show actual shapes of regions of a device, and are not intended to limit the scope of the example implementations.

An embodiment of this application provides an electronic device. The electronic device is, for example, a consumer electronic product, a home electronic product, a vehicle-mounted electronic product, a financial terminal product, or a communication electronic product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smart watch or a smart band), a virtual reality (virtual reality, VR) terminal device, an augmented reality (augmented reality, AR) terminal device, an uncrewed aerial vehicle, or the like. The home electronic product is, for example, an intelligent lock, a television, a remote management, a refrigerator, a small household charging appliance (such as a soy milk maker or a robot vacuum), or the like. The vehicle-mounted electronic product is, for example, a vehicle-mounted navigator, a vehicle-mounted high-density digital video disc (digital video disc, DVD), or the like. The financial terminal product is, for example, an automated teller machine (automated teller machine, ATM), a terminal for self-help services, or the like. The communication electronic product is, for example, a communication device such as a server, a memory, a base station, or the like.

A specific form of the electronic device is not specially limited in embodiments of this application. For ease of description, an example in which the electronic device is a mobile phone is used for description in the following embodiments.

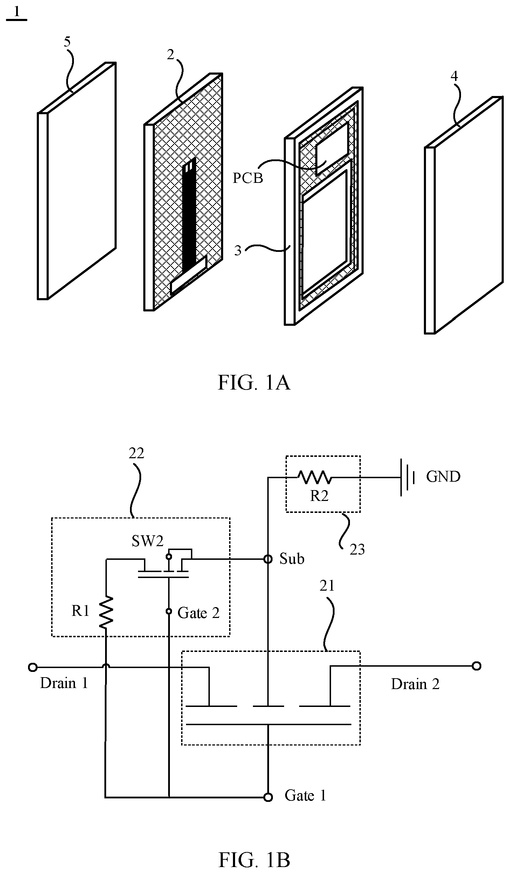

In this case, as shown in FIG. 1A, an electronic device 1 mainly includes a display module 2, a middle frame 3, a housing (or referred to as a battery cover or a rear housing) 4, and a cover plate 5.

The display module 2 is provided with a light emitting side capable of showing a displayed image and a rear surface opposite to the light emitting side. The rear surface of the display module 2 is close to the middle frame 3, and the cover plate 5 is disposed on the light emitting side of the display module 2.

The display module 2 includes a display panel (display panel, DP).

In a possible embodiment of this application, the display module 2 is a liquid crystal display module. In this case, the display panel is a liquid crystal display (liquid crystal display, LCD). In view of this, the display module 2 further includes a backlight module (backlight unit, BLU) located on a rear surface of the liquid crystal display (away from a surface of a side that is of the LCD and that is used to display an image).

The backlight module may provide a light source for the liquid crystal display, so that each sub-pixel (sub-pixel) in the liquid crystal display can emit light to display an image.

Alternatively, in another possible embodiment of this application, the display module 2 is an organic light emitting diode display module. In this case, the display panel is an organic light emitting diode (organic light emitting diode, OLED) display. Because an electroluminescence layer is disposed in each sub-pixel in the OLED display, the OLED display may implement self-luminescence after receiving an operating voltage. In this case, the backlight module does not need to be disposed in the display module 2 having the OLED display.

The cover plate 5 is located on a side that is of the display module 2 and that is away from the middle frame 3. The cover plate 5 may be, for example, a cover glass (cover glass, CG), and the cover glass may have special toughness. The middle frame 3 is located between the display module 2 and the housing 4. A surface that is of the middle frame 3 and that is away from the display module 2 is used to install internal elements such as a battery, a printed circuit board (printed circuit board, PCB), a camera (camera), an antenna, and the like. After the housing 4 covers the middle frame 3, the internal elements are located between the housing 4 and the middle frame 3.

The electronic device 1 further includes a processor (central processing unit, CPU) chip, a radio frequency chip, a radio frequency power amplifier (power amplifier, PA) chip, a system on a chip (system on a chip, SoC), a power management integrated circuit chip (power management integrated circuit, PMIC), a storage chip (for example, a high bandwidth memory (high bandwidth memory, HBM)), an audio processor chip, a touchscreen control chip, a NAND flash (flash memory), an image sensor chip, a charging protection chip, and the like that are disposed on the PCB. The PCB is configured to carry the foregoing chips, and completes signal interaction with the foregoing chips.

Performance, such as reliability and the like of a chip (or referred to as a logic integrated device, or referred to as an integrated circuit device) directly affects a service life and performance of an electronic device.

A structure of a circuit of a charging protection chip is shown. As shown in FIG. 1B, the charging protection circuit includes a first switching transistor 21, a pull-up circuit 22, and a pull-down circuit 23.

The first switching transistor 21 includes a first drain Drain 1, a second drain Drain 2, a first gate Gate 1, and a substrate electrode Sub. The first drain Drain 1 is configured to receive a signal from the second drain Drain 2, the second drain Drain 2 is configured to receive a signal from the first drain Drain 1, and the first gate Gate 1 is configured to control the first switching transistor to be turned on or turned off.

The first switching transistor 21 may be a high electron mobility transistor (high electron mobility transistor, HEMT) device (for example, a GaN-based HEMT, a Ga₂O₃-based HEMT, or a GaAs-based HEMT), or the first switching transistor 21 may be a metal-oxide-semiconductor field-effect transistor (metal-oxide-semiconductor field-effect transistor, MOSFET) device.

The pull-up circuit 22 includes a first resistor R1 and a second switching transistor SW2. The pull-up circuit 22 is configured to adjust a potential of the substrate electrode Sub to a threshold when the first switching transistor 21 is turned on.

A second gate Gate 2 of the second switching transistor SW2 is coupled to the first gate, a first electrode of the second switching transistor SW2 is coupled to a second end of the first resistor R1, and a second electrode of the second switching transistor SW2 is coupled to the substrate electrode Sub.

A first end of the first resistor R1 is coupled to the first gate Gate 1, and the second end of the first resistor R1 is coupled to the substrate Sub by using the second switching transistor SW2.

The pull-down circuit 23 includes a second resistor R2. A first end of the second resistor R2 is coupled to the substrate electrode Sub, and a second end of the second resistor R2 is coupled to a reference ground end GND. The pull-down circuit 23 is configured to adjust the potential of the substrate electrode Sub to a potential of a fixed signal end or a potential between the first gate Gate 1 and the fixed signal end when the first switching transistor 21 is turned off.

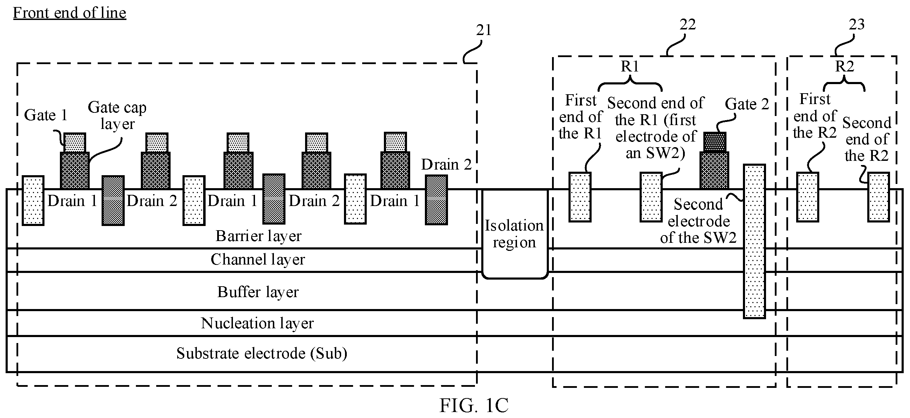

As shown in FIG. 1C, both the first switching transistor 21 and the second switching transistor SW2 are HEMT devices, and the first switching transistor 21 and the second switching transistor SW2 share a same substrate. The first resistor R1 and the second resistor R2 may be formed synchronously with the first drain Drain 1 and the second drain Drain 2 of the HEMT device.

As shown in FIG. 1C, electronic elements such as the first switching transistor 21, the second switching transistor SW2, the first resistor R1, the second resistor R2, and the like in the charging protection circuit are formed by using a front end of line (front end of line, FEOL).

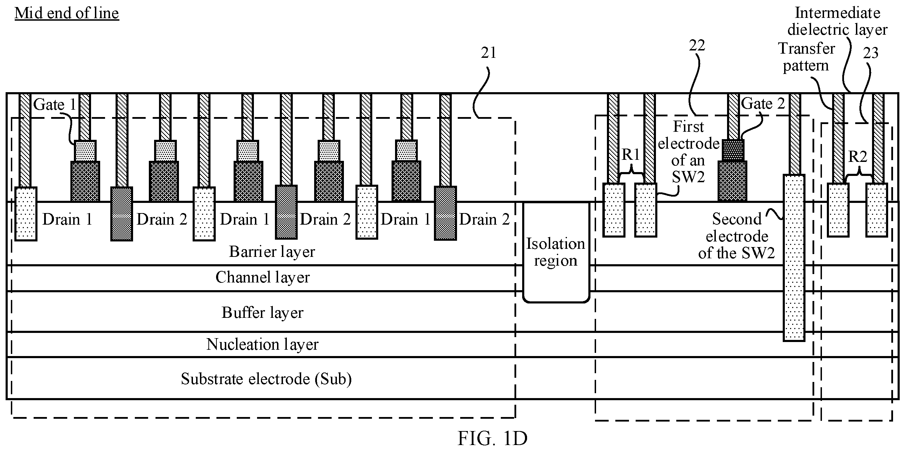

As shown in FIG. 1D, an intermediate layer is formed by using a mid end of line (mid end of line, MEOL). The intermediate layer includes a transfer layer having a plurality of transfer patterns and an intermediate dielectric layer surrounding an outer side of the transfer patterns. The transfer patterns lead conductive portions in the electronic elements to a same plane.

The conductive portions in the electronic elements are, for example, the first drain Drain 1, the second drain Drain 2, the first gate Gate 1, the second gate Gate 2, the first electrode and the second electrode of the second switching transistor SW2, the two ends of the first resistor R1, and the two ends of the second resistor R2.

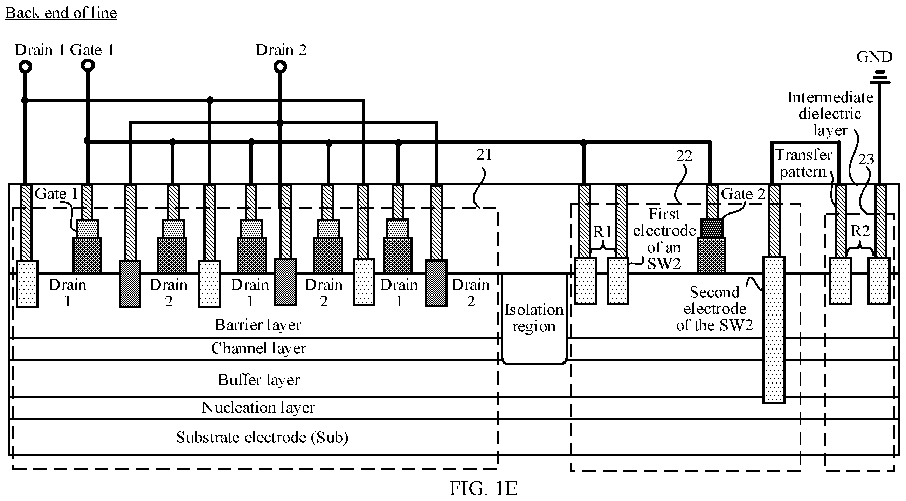

As shown in FIG. 1E, a wiring layer on the intermediate layer is formed by using a back end of line (back end of line, BEOL), and leads the conductive portions in the charging protection circuit to a signal end on a surface. After the chip is formed, the signal end is exposed on the surface of the chip.

It should be noted that, the mid end of line may alternatively be classified into the back end of line or the front end of line, or the mid end of line is not included. The solution provided in embodiments of this application is merely an example. This is not limited.

As a chip size is reduced, in the back end of line, to reduce a resistor-capacitor delay (RC delay) of the chip and improve high-frequency performance of the chip, an ultra-low dielectric constant material (Ultra low K, ULK) needs to be introduced as a dielectric layer (which can reduce parasitic capacitance between metal patterns). However, mechanical performance (such as hardness, Young's modulus, and the like) of this material deteriorates due to impact of a porous structure of the material. Processes such as etching, plasma pre-cleaning, and the like in the back end of line have low tolerance.

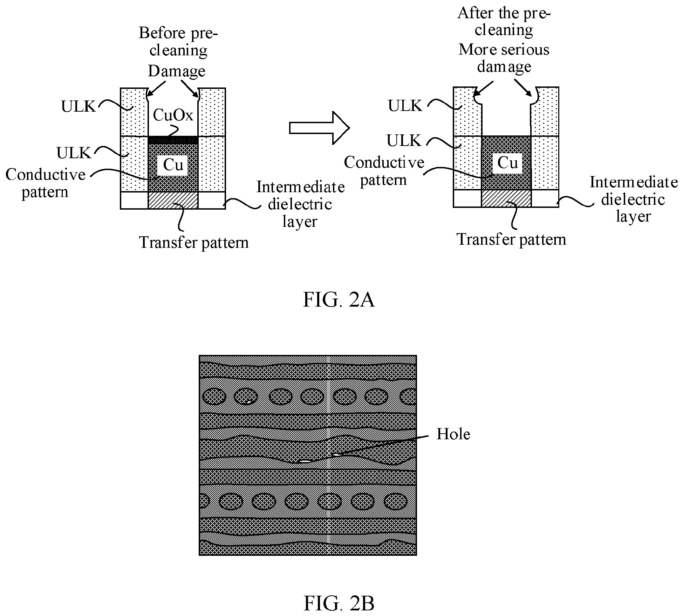

As shown in FIG. 2A, a structure of a wiring layer above one transfer pattern is used as an example to describe the back end of line. In the back end of line, after one wiring layer is formed on the transfer pattern (which certainly, may alternatively be a conductive portion in FIG. 1C), a conductive pattern at the upper wiring layer needs to be pre-cleaned (pre-cleaned) before a next wiring layer is formed, to remove oxide on a surface of the conductive pattern. Then, the wiring layer is formed through physical vapor deposition (physical vapor deposition, PVD) and chemical-mechanical planarization (chemical-mechanical planarization, CMP). FIG. 2A is illustrated by using an example in which a material of the conductive pattern is copper (Cu) and the oxide on the surface of the conductive pattern is copper oxide (CuOx).

When a via for placing a conductive pattern at the next wiring layer is formed through etching, a ULK layer is damaged. In a subsequent pre-cleaning procedure, an existing mainstream pre-cleaning process is to bombard an oxide layer on the surface of the conductive pattern by using argon ion plasma (Ar plasma), to sputter out the oxide and reduce resistivity of a conductive pattern at an adjacent wiring layer.

However, as shown in FIG. 2A, due to the non-directional bombardment of an argon ion (Ar) in the pre-cleaning process, the damage to the ULK layer is aggravated. The damage may be referred to as a kink (kink). As shown in FIG. 2B, due to existence of the damage, after the conductive pattern is subsequently formed, holes, or referred to as metal damage (metal damage), exist between the conductive pattern and the ULK layer. Due to the existence of the metal damage, electron migration is prone to occur in a running procedure of a chip. The electron migration causes continuous expansion of the metal damage, and the ULK layer is hollowed out. Consequently, a short circuit occurs between adjacent conductive patterns, and chip reliability is negatively affected.

To resolve the foregoing problems, in some embodiments, the pre-cleaning process is completed in a processing manner of mixing a hydrogen free radical (H*) and the argon ion.

In this way, the H* has higher reactivity to reduce the oxide on the surface layer of the conductive pattern, to weaken the bombardment of the argon ion. Therefore, the damage to the ULK layer is reduced.

However, a material of the ULK layer mainly includes silicon oxycarbide (SiOC), silicon oxycarbonnitride (SiOCN), porous SiOCN, and the like. In this technique, bombardment of the H* causes re-deposition of silicon oxide (SiOx) in the ULK layer. To remove the silicon oxide deposited on the surface of the conductive pattern, the bombardment of the argon ion also needs to be used in this technique. Therefore, a problem of the damage to the ULK layer caused by the bombardment of the argon ion still exists. In addition, due to occurrence of the damage, when a conductive film is subsequently formed by using the PVD, a seed layer is extremely difficult to fill the damage. This causes discontinuous seed layers. The discontinuous seed layers cause a hole in the region in a subsequent electroplating process, and directly cause metal damage after the CMP. Especially, as a line width gradually becomes narrow, little damage also adversely affects electroplating of the wiring layer.

In view of this, embodiments of this application further provide a chip preparation method. A chip obtained by using the chip preparation method can help resolve a problem that the ULK layer is damaged in a pre-cleaning procedure. The following uses several examples to describe the chip and the chip preparation method provided in embodiments of this application.

### Example 1

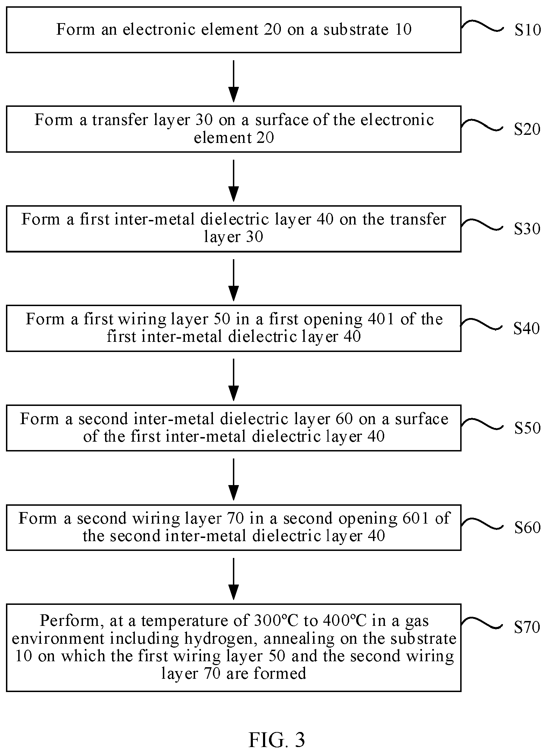

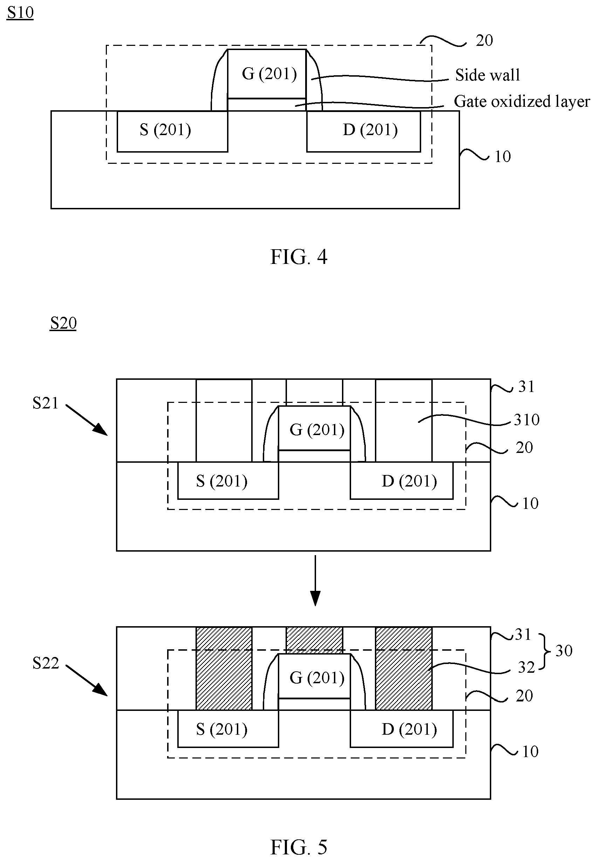

A chip preparation method is provided. As shown in FIG. 3, the chip preparation method includes the following steps. S10. As shown in FIG. 4, form an electronic element 20 on a substrate 10.

In view of this, after step S10 is performed, as shown in FIG. 4, the electronic element 20 included in a chip is disposed on the substrate 10, and each electronic element 20 includes at least one conductive portion 201.

When the chip is used in an electronic device such as a base station or the like as a radio frequency device, a material of the substrate 10 is an insulation material. When the chip is used in an electronic device such as a mobile phone or the like as a power device, a material of the substrate 10 is a conductive material.

The electronic element 20 is a basic element in an electronic circuit, and has at least one conductive portion 201 (or referred to as a metal contact or a lead contact). The conductive portion 201 is interconnected with and coupled to a wiring layer, to complete signal transmission. The electronic element 20 may be a resistor, a capacitor, an inductor, a transistor, a diode, an operational amplifier, a resistor array, a logic gate, or the like.

The chip may include one electronic element 20, or may include a plurality of electronic elements 20. In the chip preparation method provided in this embodiment of this application, one electronic element 20 in the chip is merely used as an example to describe a structure of each portion in the chip. When the chip includes the plurality of electronic elements 20, back end of lines of the electronic elements 20 may be similar or the same. In addition, when the chip includes the plurality of electronic elements 20, the plurality of electronic elements 20 may be a same type of electronic elements, or may be different types of electronic elements. A quantity, a type, and an arrangement manner of the electronic elements 20 in the chip are not limited in this embodiment of this application, and the electronic element 20 may be appropriately set based on requirements.

For example, as shown in FIG. 4, the electronic element 20 is a complementary metal oxide semiconductor (complementary metal oxide semiconductor, CMOS) device. A source S, a drain D, and a gate G of the CMOS are all conductive portions 201 of the CMOS.

Alternatively, for example, the electronic element 20 is a high electron mobility transistor (high electron mobility transistor, HEMT). A source S, a drain D, and a gate G of the HEMT are all conductive portions 201 of the HEMT.

Alternatively, for example, the electronic element 20 is a heterojunction bipolar transistor (heterojunction bipolar transistor, HBT). An emitter (E), a collector (C), and a base (B) of the HBT are all conductive portions 201 of the HBT.

Alternatively, for example, the electronic element 20 is a bipolar junction transistor (bipolar junction transistor, BJT). An emitter (E), a collector (C), and a base (B) of the BJT are all conductive portions 201 of the BJT.

It should be emphasized that the conductive portion 201 of the electronic element 20 may alternatively be a component coupled to an electrode in the electronic element 20. This embodiment of this application is not limited to that the conductive portion 201 needs to be the electrode in the electronic element 20.

S20. As shown in FIG. 5, form a contact layer on a surface of the electronic element 20.

The intermediate layer, as a forming layer of a mid end of line, is configured to lead the conductive portion 201 in the electronic element 20 to a same plane.

For example, step S20 includes the following steps.

S21. Form an intermediate dielectric layer 31 on the surface of the electronic element 20.

The intermediate dielectric layer 31 may also be referred to as an inter-level dielectric layer (inter-level dielectric, ILD). The intermediate dielectric layer 31 has an opening 301, where the opening 301 is configured to expose the conductive portion 201 in the electronic element 20.

A shape of the opening 301 is not limited in this embodiment of this application. The opening 301 may be in a hole shape, a strip shape, or another shape based on requirements. The opening 301 may expose a partial region of a top surface that is of the conductive portion 201 and that is away from the substrate 10. Alternatively, the opening 301 may expose an entire region of a top surface that is of the conductive portion 201 and that is away from the substrate 10.

A quantity of openings 301 is not limited in this embodiment of this application, provided that the opening 301 can expose a to-be-exposed conductive portion 201. It should be emphasized that one conductive portion 201 may be exposed by one opening 301. In other words, only one opening 301 may be disposed above one conductive portion 201. One conductive portion 201 may alternatively be exposed by a plurality of openings 301. In other words, the plurality of openings 301 may be disposed above one conductive portion 201. Alternatively, a plurality of conductive portions 201 may be exposed by a same opening 301. In other words, one opening 301 exposes the plurality of conductive portions 201 (for example, the plurality of conductive portions 201 transmit or receive a same signal).

For example, an intermediate dielectric film may be formed by using chemical vapor deposition (chemical vapor deposition, CVD), physical vapor deposition, or another deposition method, and then the opening 301 is formed on the intermediate dielectric film by using lithography and etching methods, to obtain, through preparing, the intermediate dielectric layer 31.

A material of the intermediate dielectric layer 31 may include, for example, silicon oxide (for example, silicon dioxide SiO2), silicon nitride (for example, silicon nitride Si3N4), doped oxide of silicon, fluoride oxide of silicon, carbon-doped oxide of silicon, or various low-dielectric-constant (k) dielectric materials known in conventional technologies and a combination thereof.

S22. Form a transfer pattern 32 in the opening 301.

The transfer pattern 32 fills the opening 301, and the transfer pattern 32 is in contact with and coupled to the conductive portion 201 of the electronic element 20 through the opening 301. A plurality of transfer patterns 32 are used as transfer layers in the intermediate layer 30. It can be learned from the foregoing descriptions of the quantity of openings 301 that, one conductive portion 201 may be in contact with and coupled to one transfer pattern 32, one conductive portion 201 may be coupled to the plurality of transfer patterns 32, or the plurality of conductive portions 201 may be coupled to one transfer pattern 32. This may be appropriately set based on requirements.

For example, a transfer film may be formed by using any appropriate deposition process, such as electroplating, chemical vapor deposition, or physical vapor deposition, and then the transfer film is patterned with reference to a process such as chemical-mechanical planarization, the etching, or the like, to form the transfer pattern 32.

The transfer pattern 32 may be a conductive line, and may alternatively be a conductive column. The transfer pattern 32 may be appropriately set based on requirements. A material of the transfer pattern 32 may be a conductive material. For example, the material of the transfer pattern 32 includes metal or a metal alloy. For example, the material of the transfer pattern 32 includes copper (Cu), aluminum (Al), titanium (Ti), zirconium (Zr), hafnium (Hf), vanadium (V), ruthenium (Ru), cobalt (Co), nickel (Ni), palladium (Pd), platinum (Pt), tungsten (W), silver (Ag), gold (Au), or an alloy thereof.

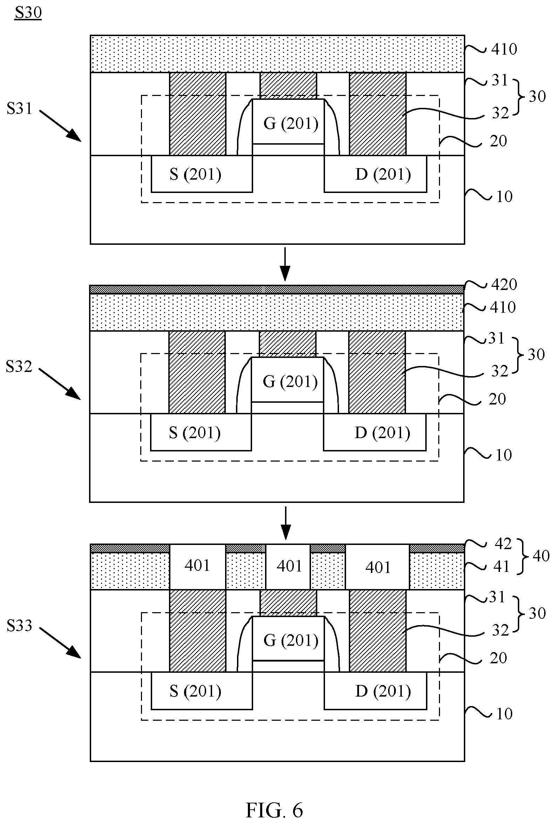

S30. As shown in FIG. 6, form a first inter-metal dielectric layer (inter-metal dielectric, IMD) 40 on the intermediate layer 30.

The first inter-metal dielectric layer 40 has a first opening 401, and the first opening 401 exposes the transfer pattern 32. The first opening 401 may expose a partial region of a top surface that is of the transfer pattern 32 and that is away from the substrate 10. Alternatively, the first opening 401 may expose an entire region of a top surface that is of the transfer pattern 32 and that is away from the substrate 10.

The first inter-metal dielectric layer 40 may be of a single-layer structure, or may be of a stacked structure. This is not limited in this embodiment of this application. When the first inter-metal dielectric layer 40 is of a single-layer structure, a material of the first inter-metal dielectric layer 40 may be the same as the material of the intermediate dielectric layer 31.

An example in which the first inter-metal dielectric layer 40 is of a stacked structure is used. For example, step S30 includes the following steps.

S31. Form a first ULK film 410 on the intermediate layer 30.

For example, the first ULK film 410 may be formed by using chemical vapor deposition, physical vapor deposition, or another deposition method.

A material of the first ULK film 410 may include, for example, silicon oxycarbide (SiOC), silicon oxycarbonnitride (SiOCN), and porous SiOCN.

S32. Form a first dielectric film 420 on a surface of the first ULK film 410.

For example, the first dielectric film 420 may be formed by using chemical vapor deposition, physical vapor deposition, or another deposition method.

A material of the first dielectric film 420 may include, for example, silicon oxide, silicon nitride, doped oxide of silicon, fluoride oxide of silicon, carbon-doped oxide of silicon, or any low-dielectric-constant (k) dielectric material known in conventional technologies and a combination thereof.

S33. Form the first opening 401 in the first ULK film 410 and the first dielectric film 420.

The first opening 401 passes through the first ULK film 410 and the first dielectric film 420, and the first opening 401 exposes the transfer pattern 32. The first opening 401 may expose the partial region of the top surface that is of the transfer pattern 32 and that is away from the substrate 10. Alternatively, the first opening 401 may expose the entire region of the top surface that is of the transfer pattern 32 and that is away from the substrate 10.

A shape of the first opening 401 is not limited in this embodiment of this application. The first opening 401 may be in a hole shape, a strip shape, or another shape. The shape of the first opening 401 may be appropriately set based on a shape of a to-be-formed first conductive pattern.

A quantity of first openings 401 is not limited in this embodiment of this application, provided that the first opening 401 can expose a to-be-exposed transfer pattern 32. It should be emphasized that one transfer pattern 32 may be exposed by one first opening 401. In other words, only one first opening 401 may be disposed above one transfer pattern 32. One transfer pattern 32 may alternatively be exposed by a plurality of first openings 401. In other words, the plurality of first openings 401 may be disposed above one transfer pattern 32. Alternatively, the plurality of transfer patterns 32 may be exposed by a same first opening 401. In other words, one first opening 401 exposes the plurality of transfer patterns 32.

For example, the first ULK film 410 and the first dielectric film 420 may be patterned by using lithography and etching processes, to form the first opening 401, so that the first inter-metal dielectric layer 40 is obtained.

In this case, as shown in FIG. 6, the first inter-metal dielectric layer 40 includes a first UKL layer 41 and a first dielectric layer 42 that are disposed in a stacked manner.

In some embodiments, a dielectric constant (k) of the first dielectric layer 42 is greater than a dielectric constant (k) of the first ULK layer 41, so that the first dielectric layer 42 has better mechanical strength to cope with impact of a subsequent process on the first ULK layer 41, to protect the first ULK layer 41 and improve high-frequency performance of the chip.

In some embodiments, mechanical performance (such as hardness, Young's modulus, and the like) of the first dielectric layer 42 is greater than mechanical performance of the first ULK layer 41, to improve tolerance of the first inter-metal dielectric layer 40 to processes such as the etching, plasma pre-cleaning, and the like in a back end of line.

In some embodiments, a thickness of the first dielectric layer 42 is less than a thickness of the first ULK layer 41, so that impact of the first dielectric layer 42 on a resistor-capacitor delay of the chip is reduced as much as possible when the first inter-metal dielectric layer 40 meets high tolerance.

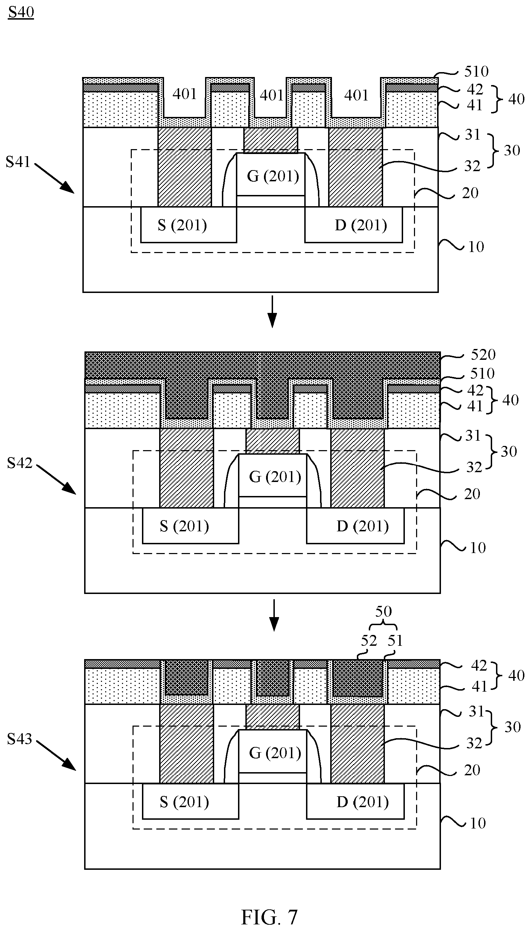

S40. As shown in FIG. 7, form a first wiring layer 50 in the first opening 401 of the first inter-metal dielectric layer 40.

The first wiring layer 50 is coupled to the transfer pattern 32, and the first wiring layer 50 is coupled to the conductive portion 201 of the electronic element 20 by using the transfer pattern 32, to complete the signal transmission.

In some embodiments, the first wiring layer 50 includes at least one first conductive pattern 52, the first conductive pattern 52 is disposed in each first opening 401, and the first conductive pattern 52 is coupled to the transfer pattern 32.

In some other embodiments, as shown in FIG. 7, the first wiring layer 50 includes at least one first diffusion barrier pattern 51 and at least one first conductive pattern 52. The first conductive pattern 52 is disposed in each first opening 401, the first diffusion barrier pattern 51 is further disposed in at least a part of first openings 401, and the first diffusion barrier pattern 51 is separately coupled to the first conductive pattern 52 and the transfer pattern 32.

The first diffusion barrier pattern 51 is located on an outer side of the first conductive pattern 52, and covers a side surface of the first conductive pattern 52 and a bottom surface that is of the first conductive pattern 52 and that is close to the substrate 10. Alternatively, it is understood as that the first diffusion barrier pattern 51 wraps a periphery of the first conductive pattern 52, and a top surface that is of the first conductive pattern 52 and that is away from the substrate 10 is exposed. The first diffusion barrier pattern 51 is in contact with a top surface of the transfer pattern 32, and the first conductive pattern 52 is coupled to the transfer pattern 32 by using the first diffusion barrier pattern 51.

The first diffusion barrier pattern 51 is disposed on the outer side of the first conductive pattern 52, so that metal ion diffusion in the first conductive pattern 52 can be effectively prevented, electron migration can be resisted, and the resistor-capacitor delay of the chip can be reduced.

The first conductive pattern 52 may be a conductive column, a conductive line, or a conductive structure in another shape. This is not limited in this embodiment of this application, and the first conductive pattern 52 may be appropriately set based on requirements.

An example in which the first wiring layer 50 includes the first diffusion barrier pattern 51 and the first conductive pattern 52 is used. For example, step S40 includes the following steps.

S41. Form a first diffusion barrier film 510 on the first inter-metal dielectric layer 40.

The first diffusion barrier film 510 covers at least an inner wall of the first opening 401, the first diffusion barrier film 510 may further cover a bottom part (or understood as the top surface of the transfer pattern 32) of the first opening 401, and the first diffusion barrier film 510 may further cover at least a part of a top surface of the first inter-metal dielectric layer 40. For example, the first diffusion barrier film 510 may be formed by using chemical vapor deposition, physical vapor deposition, or another deposition method.

A material of the first diffusion barrier film 510 may include, for example, tantalum nitride (TaN), a tantalum/tantalum nitride (Ta/TaN) composite layer or a titanium/titanium nitride (Ti/TiN) composite layer, or another conductive material that has a same function, such as titanium silicon nitride (TiSiN), tungsten nitride (WNx), tungsten nitrocarbide (WNxCy), a manganese-silicon-oxygen compound, or the like.

Film thicknesses of all portions of the first diffusion barrier film 510 may be equal or may be unequal. In FIG. 7, an example in which a thickness of a portion that is of the first diffusion barrier film 510 and that is in contact with the top surface of the transfer pattern 32 is greater than a thickness of a portion that is of the first diffusion barrier film 510 and that is in contact with the inner wall of the first opening 401 is used for illustration.

S42. Form a third metal film 520 on the first diffusion barrier film 510.

The third metal film 520 fills the first opening 401, and the third metal film 520 may cover the first inter-metal dielectric layer 40. It may be understood that, it can be learned from the foregoing descriptions of the first diffusion barrier film 510 that the inner wall of the first opening 401 is also covered with the first diffusion barrier film 510. In this case, that the third metal film 520 fills the first opening 401 means that the third metal film 520 fills the remaining region of the first opening 401.

A material of the third metal film 520 includes first metal. For example, the material of the third metal film 520 is first metal. For example, the first metal is copper, and the material of the third metal film 520 is a copper element.

For example, the third metal film 520 may be formed by using any appropriate deposition process, such as electroplating, chemical vapor deposition, or physical vapor deposition.

S43. Pattern the first diffusion barrier film 510 and the third metal film 520, to form the first diffusion barrier pattern 51 and the first metal pattern 52, so that the first wiring layer 50 is formed.

For example, the first diffusion barrier film 510 and the third metal film 520 may be patterned by using a process such as chemical-mechanical planarization, etching, or the like, to form the first diffusion barrier pattern 51 and the first metal pattern 52.

The patterning of the first diffusion barrier film 510 and the third metal film 520 may be completed in a same process. Alternatively, the third metal film 520 may be first patterned, and then the first diffusion barrier film 510 is patterned. Alternatively, the first diffusion barrier film 510 may be formed, and the first diffusion barrier film 510 is patterned to form the first diffusion barrier pattern 51. Then, the third metal film 520 may be formed, and the third metal film 520 may be patterned. A manner of forming the first diffusion barrier pattern 51 and the first metal pattern 52 is not limited in this embodiment of this application. The foregoing steps S41 to S43 are merely examples.

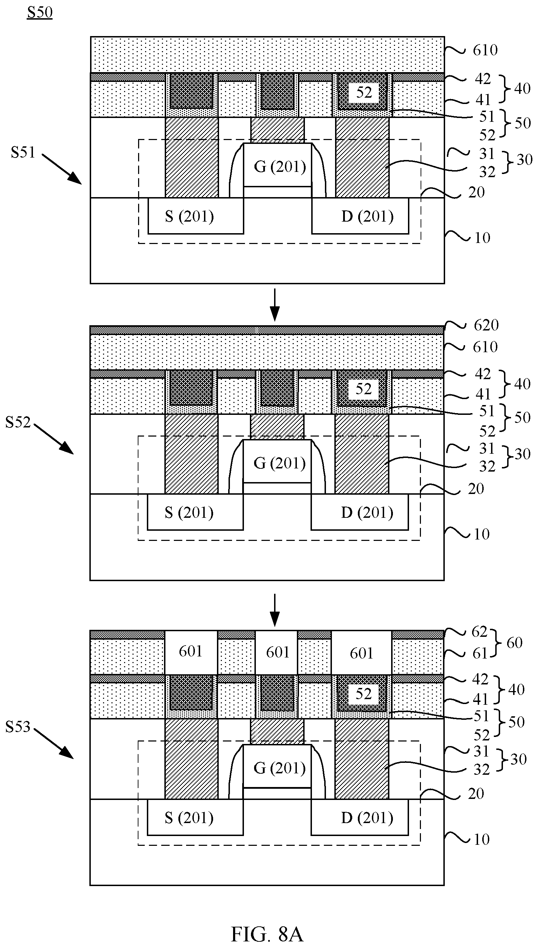

S50. As shown in FIG. 8A, form a second inter-metal dielectric layer 60 on a surface of the first inter-metal dielectric layer 40.

The second inter-metal dielectric layer 60 has a second opening 601, and the second opening 601 exposes the first metal pattern 52. The second opening 601 may expose a partial region of the top surface that is of the first metal pattern 52 and that is away from the substrate 10. Alternatively, the second opening 601 may expose an entire region of the top surface that is of the first metal pattern 52 and that is away from the substrate 10.

The second inter-metal dielectric layer 60 may be of a single-layer structure, or may be of a stacked structure. This is not limited in this embodiment of this application. When the second inter-metal dielectric layer 60 is of a single-layer structure, a material of the second inter-metal dielectric layer 60 may be the same as the material of the intermediate dielectric layer 31.

An example in which the second inter-metal dielectric layer 60 is of a stacked structure is used. For example, step S50 includes the following steps.

S51. Form a second ULK film 610 on the first inter-metal dielectric layer 40.

For example, the second ULK film 610 may be formed by using chemical vapor deposition, physical vapor deposition, or another deposition method.

A preparation process of the second ULK film 610 may be the same as a preparation process of the first ULK film 410, and a material of the second ULK film 610 may also be the same as the material of the first ULK film 410. S52. Form a second dielectric film 620 on a surface of the second ULK film 610.

For example, the second dielectric film 620 may be formed by using chemical vapor deposition, physical vapor deposition, or another deposition method.

A material of the second dielectric film 620 may include, for example, silicon oxide, silicon nitride, doped oxide of silicon, fluoride oxide of silicon, carbon-doped oxide of silicon, or any low-dielectric-constant (k) dielectric material known in conventional technologies and a combination thereof.

A preparation process of the second dielectric film 620 may be the same as a preparation process of the first dielectric film 420, and the material of the second dielectric film 620 may also be the same as the material of the first dielectric film 420.

S53. Form the second opening 601 in the second ULK film 610 and the second dielectric film 620.

The second opening 601 passes through the second ULK film 610 and the second dielectric film 620, and the second opening 601 exposes the first metal pattern 52. The second opening 601 may expose the partial region of the top surface that is of the first metal pattern 52 and that is away from the substrate 10. Alternatively, the second opening 601 may expose the entire region of the top surface that is of the first metal pattern 52 and that is away from the substrate 10.

A shape of the second opening 601 is not limited in this embodiment of this application. The second opening 601 may be in a hole shape, a strip shape, or another shape. The shape of the second opening 601 may be appropriately set based on a shape of a to-be-formed second conductive pattern.

A quantity of second openings 601 is not limited in this embodiment of this application, provided that the second opening 601 can expose a to-be-exposed first metal pattern 52. It should be emphasized that one first metal pattern 52 may be exposed by one second opening 601. In other words, only one second opening 601 may be disposed above one first metal pattern 52. One first metal pattern 52 may alternatively be exposed by a plurality of second openings 601. In other words, the plurality of second openings 601 may be disposed above one first metal pattern 52. Alternatively, a plurality of first metal patterns 52 may be exposed by a same second opening 601. In other words, one second opening 601 exposes the plurality of first metal patterns 52.

For example, the second ULK film 610 and the second dielectric film 620 may be patterned by using lithography and etching processes, to form the second opening 601, so that the second inter-metal dielectric layer 60 is obtained.

In this case, as shown in FIG. 8A, the second inter-metal dielectric layer 60 includes a second UKL layer 61 and a second dielectric layer 62 that are disposed in a stacked manner.

In some embodiments, a dielectric constant (k) of the second dielectric layer 62 is greater than a dielectric constant (k) of the second ULK layer 61, so that the second dielectric layer 62 has better mechanical strength to cope with impact of a subsequent process on the second ULK layer 61, to protect the second ULK layer 61 and improve the high-frequency performance of the chip.

In some embodiments, mechanical performance (such as hardness, Young's modulus, and the like) of the second dielectric layer 62 is greater than mechanical performance of the second ULK layer 61, to improve tolerance of the second inter-metal dielectric layer 60 to the processes such as the etching, the plasma pre-cleaning, and the like in the back end of line.

In some embodiments, a thickness of the second dielectric layer 62 is greater than a thickness of the second ULK layer 61, so that impact of the second dielectric layer 62 on the resistor-capacitor delay of the chip is reduced as much as possible when the second inter-metal dielectric layer 60 meets high tolerance.

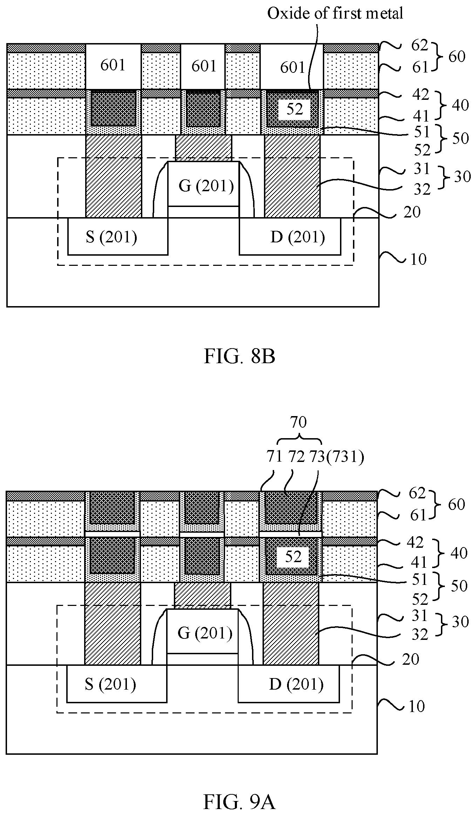

After the second inter-metal dielectric layer 60 is formed, the first conductive pattern 52 is exposed. As shown in FIG. 8B, the top surface that is of the first conductive pattern 52 and that is away from the substrate 10 is oxidized, first metal on the top surface of the first conductive pattern 52 is oxidized into oxide of the first metal, and conductivity of the first conductive pattern 52 deteriorates.

It should be emphasized that, that the top surface of the first conductive pattern 52 is oxidized is not limited to that all of the first metal on the top surface of the first conductive pattern 52 is oxidized into the oxide of the first metal, or may be that a part of the first metal is oxidized into the oxide of the first metal.

S60. Form a second wiring layer 70 in the second opening 601 of the second inter-metal dielectric layer 60.

The second wiring layer 70 is disposed on a surface of the first wiring layer 50, and is coupled to the first wiring layer 50, to complete the signal transmission.

In some embodiments, the second wiring layer 70 includes at least one second conductive pattern 72 and at least one third conductive pattern 73, the second conductive pattern 72 and the third conductive pattern 73 are disposed in each second opening 601, and the second conductive pattern 72 is coupled to the first conductive pattern 52 by using the third conductive pattern 73.

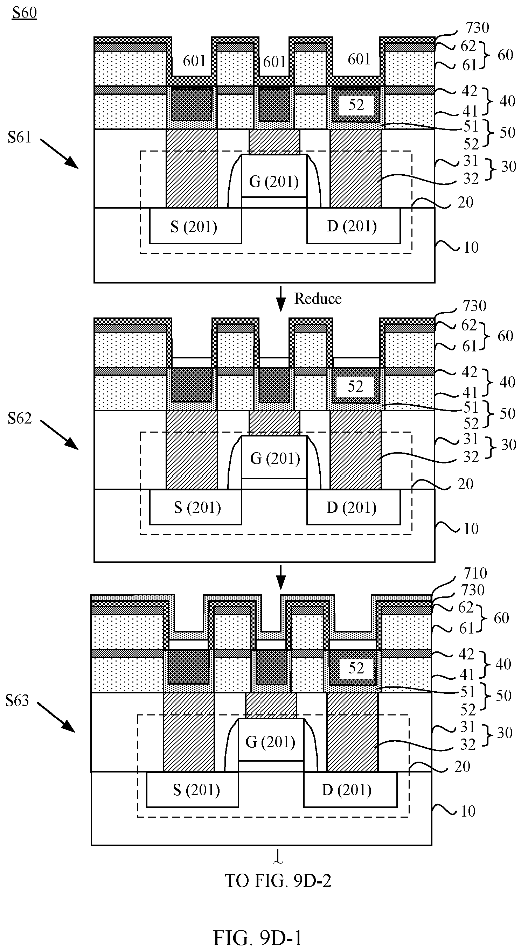

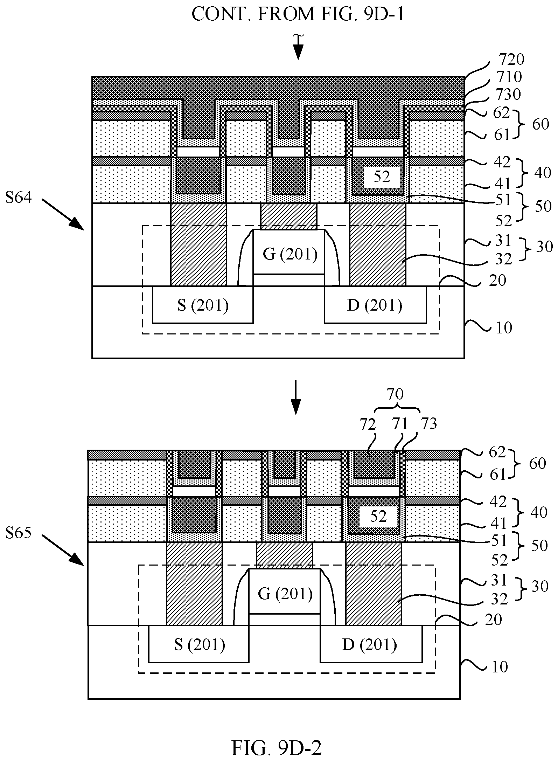

In some other embodiments, as shown in FIG. 9A, the second wiring layer 70 includes at least one second diffusion barrier layer 71, at least one second conductive pattern 72, and at least one third conductive pattern 73. The second conductive pattern 72 and the third conductive pattern 73 are disposed in each second opening 601, the second diffusion barrier layer 71 is further disposed in at least a part of second openings 601, and the second conductive pattern 72 is coupled to the first conductive pattern 52 by using the second diffusion barrier layer 71 and the third conductive pattern 73.

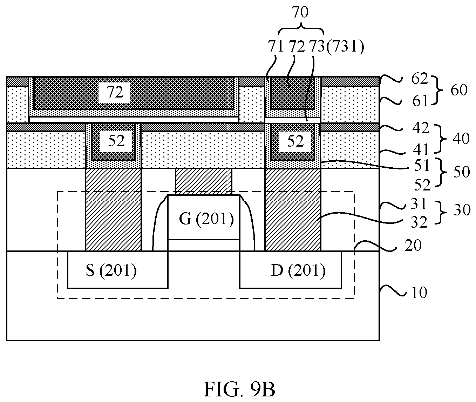

As shown in FIG. 9B, the second conductive pattern 72 may be a conductive column, or the second conductive pattern 72 may be a conductive line. Certainly, the second conductive pattern 72 may alternatively be of a conductive structure in another shape. This is not limited in this embodiment of this application, and the second conductive pattern 72 may be appropriately set based on requirements.

When the second conductive pattern 72 is a conductive line, and a coverage area of the second conductive pattern 72 is greater than the top surface of the first conductive pattern 52 below the second conductive pattern 72, a coverage area of the third conductive pattern 73 may overlap the top surface of the first conductive pattern 52, and the coverage area of the third conductive pattern 52 may alternatively be greater than the top surface of the first conductive pattern 52.

The second diffusion barrier layer 71 is located on an outer side of the second conductive pattern 72, and covers a side surface of the second conductive pattern 72 and a bottom surface that is of the second conductive pattern 72 and that is close to the substrate 10. In addition, the second diffusion barrier layer 71 is located between the second conductive pattern 72 and the third conductive pattern 73.

The third conductive pattern 73 includes at least a first portion 731 located on a side that is of the second diffusion barrier layer 71 and that is close to the first conductive pattern 52. In other words, the third conductive pattern 73 includes at least the first portion 731 located between the second diffusion barrier layer 71 (or the second conductive pattern 72) and the first conductive pattern 52.

The first portion 731 of the third conductive pattern 73 is in direct contact with the first conductive pattern 52, so that the first portion 731 of the third conductive pattern 73 is coupled to the first conductive pattern 52. The first portion 731 of the third conductive pattern 73 is coupled to the second conductive pattern 72 by using the second diffusion barrier layer 71, so that the second wiring layer 70 is coupled to the first wiring layer 50.

For example, as shown in FIG. 9B, the third conductive pattern 73 includes the first portion 731 located on the side that is of the second diffusion barrier layer 71 and that is close to the first conductive pattern 52.

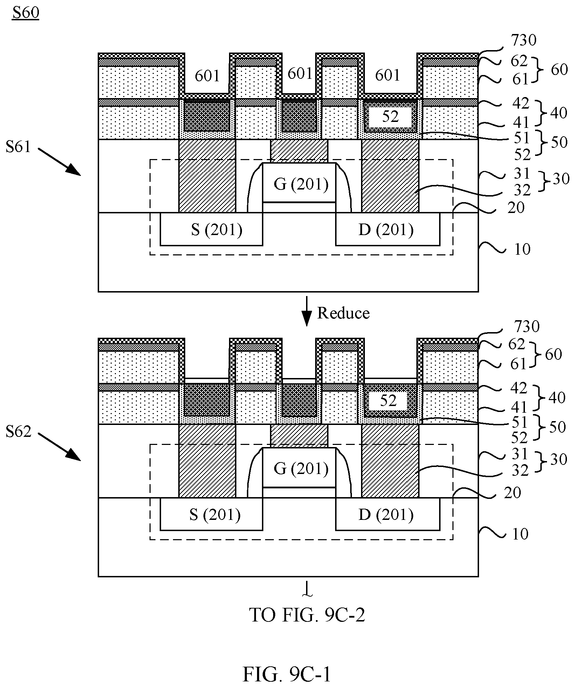

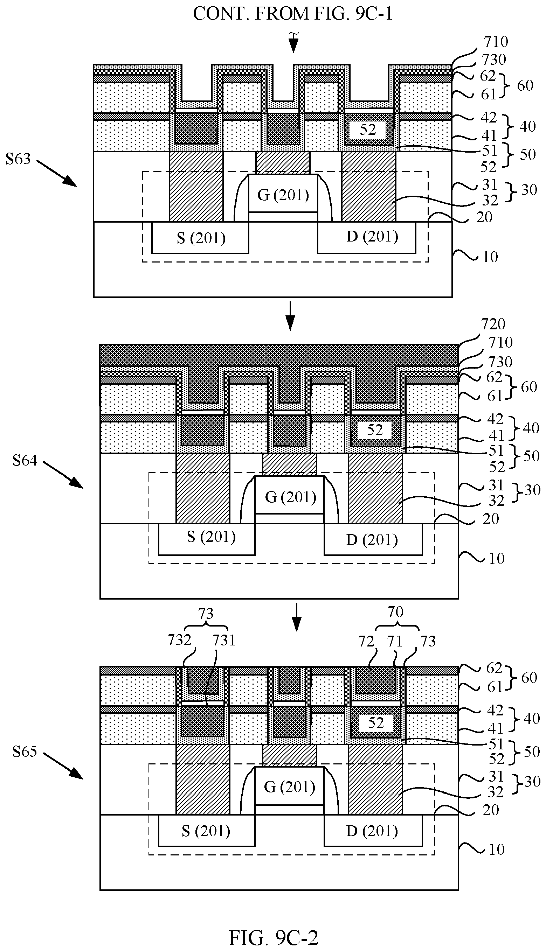

Alternatively, for example, as shown in FIG. 9C-2, the third conductive pattern 73 includes the first portion 731 located on the side that is of the second diffusion barrier layer 71 and that is close to the first conductive pattern 52 and a second portion 732 disposed on the side surface of the second conductive pattern 72 (or the second diffusion barrier layer 71).

Due to different preparation processes, structures of the first portion 731 and the second portion 732 of the third conductive pattern 73 are also different. The following describes the structures of the first portion 731 and the second portion 732 of the third conductive pattern 73 with reference to the processes.

For example, as shown in FIG. 9C-1, step S60 includes the following steps.

S61. Form a first metal film 730 on the first inter-metal dielectric layer 40.

The first metal film 730 is in contact with, by using the second opening 601, the top surface that is of the first conductive pattern 52 and that is away from the substrate 10. In this case, a material of the top surface of the first conductive pattern 52 includes the oxide of the first metal, or a material of the top surface of the first conductive pattern 52 is completely the oxide of the first metal.

A material of the first metal film 730 includes second metal, and oxide of the second metal is a conductive material. In addition, reactivity of the second metal is greater than reactivity of the first metal. In other words, electronegativity of the second metal is close to or greater than electronegativity of the first metal in the first conductive pattern 52, or reactive activity of the second metal is greater than reactive activity of the first metal.

Reactivity of a chemical element indicates a difficulty degree of which the element reacts with another substance. If an element is easier to react with another substance, the element is more active. If an element is more difficult to react with another substance, the element is more inactive, in other words, more stable. A reactivity level may be queried and compared by using a periodic table of elements.

For example, the first metal included in the first conductive pattern 52 is copper (Cu), and the second metal included in the first metal film 730 is ruthenium (Ru), iridium (Ir), or rhodium (Rh).

For a method for forming the first metal film 730, for example, as shown in FIG. 9C-1, the first metal film 730 is formed on the first inter-metal dielectric layer 40 by using an atomic layer deposition (atomic layer deposition, ALD) process.

Thicknesses of all portions of the first metal film 730 formed by using the ALD process are equal or approximately equal, and a surface of the first metal film 730 is planar or approximately planar.

Alternatively, for example, as shown in FIG. 9D-1 and FIG. 9D-2, the first metal film 730 is formed on the first inter-metal dielectric layer 40 by using a conventional physical vapor deposition (physical vapor deposition, PVD) (where a frequency is about 13.6 MHz) process.

Thicknesses of all portions of the first metal film 730 formed by using the conventional PVD process are equal or approximately equal, so that a thin first metal film 730 can be formed, and a surface of the first metal film 730 is an uneven curved surface. For example, the surface of the first metal film 730 is a wave surface.

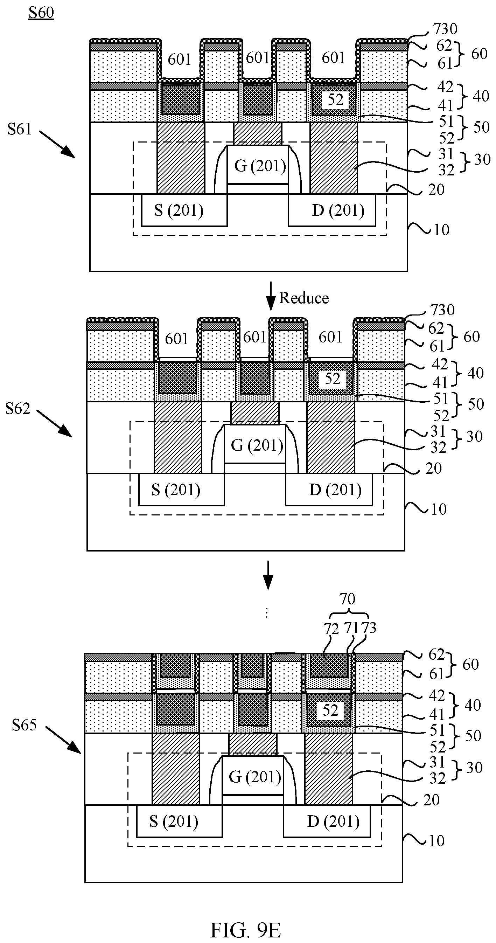

Alternatively, for example, as shown in FIG. 9E, the first metal film 730 is formed on the first inter-metal dielectric layer 40 by using a physical vapor deposition process at a very high frequency (very high frequency, VHF) (where a frequency is about 40.5 MHz).

Thicknesses of all portions of the first metal film 730 formed by using the VHF process may be unequal. For example, a thickness of a portion that is of the first metal film 730 and that is in contact with the top surface of the first conductive pattern 52 is greater than a thickness of a portion that is of the first metal film 730 and that is in contact with an inner wall of the second opening 601.

S62. Enable the second metal to react with the oxide of the first metal, to reduce at least a part of the oxide of the first metal on the top surface of the first conductive pattern 52 to the first metal.

For example, the second metal is strong reducible metal whose oxide is a conductor. An oxidation-reduction reaction occurs between the second metal and the oxide of the first metal, to reduce the oxide of the first metal to a first metal element, and oxidize the second metal to the oxide of the second metal.

For example, annealing is performed on the first conductive pattern 52 and the first metal film 730 at a temperature of 300°C to 400°C, so that the oxidation-reduction reaction occurs between the second metal in the first metal film 730 and the oxide of the first metal on the top surface of the first conductive pattern 52.

For example, the first metal is Cu, resistivity of copper oxide (CuOx) is about > 100 ohm-cm, and electronegativity of Cu is 1.9. The second metal is Ru, resistivity of ruthenium oxide (RuOx) is approximately 50 uohm-cm, and electronegativity of Ru is 2.2. The oxidation-reduction reaction, Ru+CuOx-RuOx+Cu, occurs at a high temperature to reduce CuOx to Cu.

It should be noted that, that the oxidation-reduction reaction occurs between the second metal in the first metal film 730 and the oxide of the first metal on the top surface of the first conductive pattern 52 is not limited to that the oxidation-reduction reaction occurs between all of the oxide of the first metal and the second metal, and is not limited to that the oxidation-reduction reaction occurs between all of the second metal and the oxide of the first metal.

In other words, the material of the top surface of the first conductive pattern 52 and a material of a portion that is of the first metal film 730 and that is in contact with the first conductive pattern 52 are related to factors such as a film thickness of the first metal film 730, an oxidation degree of the first conductive pattern 52, and duration of the reduction reaction.

For example, the oxidation-reduction reaction may occur between a part of the oxide of the first metal on the top surface of the first conductive pattern 52 and the second metal. After the reaction, a material of the top surface of the first conductive pattern 52 includes the first metal and the oxide of the first metal.

Alternatively, for example, the oxidation-reduction reaction may occur between all of the oxide of the first metal on the top surface of the first conductive pattern 52 and the second metal. After the reaction, a material of the top surface of the first conductive pattern 52 includes the first metal, and does not include the oxide of the first metal. In this case, the material of the first conductive pattern 52 is the first metal.

In either case, the material of the portion that is of the first metal film 730 and that is in contact with the first conductive pattern 52 may be completely the oxide of the second metal, or may be partially the second metal and partially the oxide of the second metal.

S63. Form a second diffusion barrier film 710 on the first metal film 730.

The second diffusion barrier film 710 covers at least a part of the surface of the first metal film 730. For example, the second diffusion barrier film 710 may be formed by using chemical vapor deposition, physical vapor deposition, or another deposition method.

A material of the second diffusion barrier film 710 may include, for example, TaN, a Ta/TaN composite layer, a Ti/TiN composite layer, or another conductive material that has a same function, such as TiSiN, WNx, WNxCy, TiZr/TiZrN, a manganese-silicon-oxygen compound, or the like.

The material, a structure, and a preparation process of the second diffusion barrier film 710 may be the same as those of the first diffusion barrier film 510.

S64. Form a second metal film 720 on the first metal film 730.

It may be understood that, when the second diffusion barrier film 710 is further formed, the second metal film 720 is located on the second diffusion barrier film 710.

The second metal film 720 fills the second opening 601, the second metal film 720 may cover the first metal film 730, and the second metal film 720 is coupled to the first conductive pattern 52 by using the second diffusion barrier film 710 and the first metal film 730.

A material of the second metal film 720 may include first metal. For example, the first metal is copper, and the material of the second metal film 720 is a copper element.

For example, the second metal film 720 may be formed by using any appropriate deposition process, such as electroplating, chemical vapor deposition, or physical vapor deposition. The material and a preparation process of the second metal film 720 may be the same as a structure of the third metal film 520.

S65. Pattern the first metal film 730 and the second metal film 720 to form the second wiring layer 70.

It may be understood that, when the second diffusion barrier film 710 is further formed, the second diffusion barrier film 710 further needs to be patterned.

For example, the first metal film 730, the second diffusion barrier film 710, and the second metal film 720 may be patterned by using a process such as chemical-mechanical planarization, etching, or the like, to form the third conductive pattern 73, the second diffusion barrier pattern 71, and the second metal pattern 72 are formed, so that the second wiring layer 70 is formed.

The patterning of the first metal film 730, the second diffusion barrier film 710, and the second metal film 720 may be completed in a same process. Alternatively, two adjacent film layers in the first metal film 730, the second diffusion barrier film 710, and the second metal film 720 may be patterned in a same process. Alternatively, the second metal film 720 may be first patterned, the second diffusion barrier film 710 may be patterned second, and then the first metal film 730 may be patterned. Alternatively, the first metal film 730 may be formed, and the first metal film 730 is patterned to form the third conductive pattern 73. Then, the second diffusion barrier film 710 may be formed, and the second diffusion barrier film 710 may be patterned to form the second diffusion barrier pattern 71. Next, the second metal film 720 may be formed, and the second metal film 720 may be patterned.

A manner of forming the third conductive pattern 73, the second diffusion barrier pattern 71, and the second metal pattern 72 is not limited in this embodiment of this application. The foregoing steps S61 to S65 are merely examples. Due to different preparation processes, in some embodiments, as shown in FIG. 9A and FIG. 9B, after the first metal film 730 is patterned, the formed third conductive pattern 73 includes the first portion 731 located between the second diffusion barrier layer 71 and the first conductive pattern 52.

In some other embodiments, as shown in FIG. 9C-1 and FIG. 9C-2 to FIG. 9E, after the first metal film 730 is patterned, the formed third conductive pattern 73 includes the first portion 731 located between the second diffusion barrier layer 71 and the first conductive pattern 52 and the second portion 732 disposed on a side surface of the second diffusion barrier layer 71 (the side surface of the second conductive pattern 72).

As shown in FIG. 9C-2, the thicknesses of all portions of the first metal film 730 formed by using the ALD process are equal or approximately equal, and the surface of the first metal film 730 is planar. In this case, thicknesses of all portions of the first portion 731 and the second portion 732 of the third conductive pattern 73 are equal or approximately equal, and surfaces of the first portion 731 and the second portion 732 are planar or approximately planar.

It may be understood that, thickness fluctuation (for example, ± 5%) within a process error range falls within that the thicknesses are equal in this embodiment of this application. Similarly, surface fluctuation (for example, ± 5%) within a process error range falls within that the surface is planar in this embodiment of this application.

The thicknesses of all portions of the first metal film 730 are equal or approximately equal, so that the thicknesses of all portions of the first portion 731 and the second portion 732 can be equal or approximately equal. A structure is simple and easy to design.

As shown in FIG. 9D-1 and FIG. 9D-2, the thicknesses of all portions of the first metal film 730 formed by using the conventional PVD process are equal or approximately equal, so that the thin first metal film 730 can be formed, and the surface of the first metal film 730 is an uneven curved surface. In this case, thicknesses of all portions of the first portion 731 and the second portion 732 of the third conductive pattern 73 are equal or approximately equal, and surfaces of the first portion 731 and the second portion 732 are curved surfaces.

The thin first metal film 730 is formed, so that a patterned third conductive pattern 73 can be thin, to reduce an area occupied by the third conductive pattern 73 in the second opening 601, increase an area occupied by the second conductive pattern 72 in the second opening 601, and improve a conductive effect of the second wiring layer 70.

As shown in FIG. 9E, the thickness of the portion that is of the first metal film 730 formed by using the VHF process and that is in contact with the top surface of the first conductive pattern 52 is greater than the thickness of the portion that is of the first metal film 730 formed by using the VHF process and that is in contact with the inner wall of the second opening 601. In this case, a thickness of the first portion 731 of the third conductive pattern 73 is greater than a thickness of the second portion 732, and the surfaces of the first portion 731 and the second portion 732 are planar or approximately planar.

The thickness of the first portion 731 of the third conductive pattern 73 is greater than the thickness of the second portion 732. The thickness of the second portion 732 may be reduced, so that impact of the thickness of the second portion 732 on an area occupied by the second conductive pattern 72 in the second opening 601 is reduced. In addition, the thickness of the first portion 731 may be increased, so that the second metal in the first portion reduces the oxide of the first metal in the first conductive pattern 52 to the first metal element as much as possible, to improve resistivity of the chip.

It can be learned from the foregoing descriptions of step S62 that the portion that is of the first metal film 730 and that is in contact with the first conductive pattern 52 is configured to perform the oxidation-reduction reaction with the oxide of the first metal in the first conductive pattern 52. Therefore, when the first conductive pattern 52 does not include the oxide of the first metal, a material of the first portion 731 in the third conductive pattern 73 includes a second metal element. When the first conductive pattern 52 includes the oxide of the first metal, a material of the first portion 731 in the third conductive pattern 73 includes the oxide of the second metal, and may further include the second metal. A material of the second portion 732 in the third conductive pattern 73 includes a second metal element. The materials of the first portion 731 and the second portion 732 of the third conductive pattern 73 may be determined by using a transmission electron microscope (transmission electron microscope, TEM) cross-section and element analysis method.

In some embodiments, after the second wiring layer 70 is formed, step S50 and step S60 may be repeated to form a plurality of inter-metal dielectric layers and wiring layers, where the inter-metal dielectric layers wrap outer sides of the wiring layers.

S70. Perform, at the temperature of 300°C to 400°C in a gas environment including hydrogen (H₂), annealing on the substrate 10 on which the first wiring layer 50 and the second wiring layer 70 are formed.

Second metal with high electronegativity has a catalytic capability of decomposing hydrogen at a high temperature (300°C) to form a hydrogen free radical (H*). The annealing is performed at the temperature of 300°C to 400°C in the gas environment including the hydrogen (for example, a mixture of the hydrogen and nitrogen), and in this case, the second metal may catalyze decomposition of H₂ into H*, and the H* has extremely strong reducibility. When the oxide of the first metal in the first conductive pattern 52 is not completely reduced, the H* can further reduce the oxide of the first metal (for example, copper oxide). This further reduces resistance of the chip.

According to the chip preparation method provided in this embodiment of this application, the reactivity of the second metal in the first metal film 730 is greater than the reactivity of the first metal in the first conductive pattern 52. In this way, the oxidation-reduction reaction occurs between the second metal and the oxide of the first metal in a high-temperature annealing environment, and the oxide of the first metal on the top surface of the first conductive pattern 52 is reduced to the first metal element. This reduces resistance of the first conductive pattern 52. A plasma pre-cleaning step is replaced with oxidation-reduction, so that damage (or referred to as a kink) to the second ULK layer 61 caused by the plasma pre-cleaning step can be avoided, to improve chip reliability.

In addition, resistivity of the oxide of the second metal is (about > four orders of magnitude) less than resistivity of the oxide of the first metal. For the finally formed chip, the material of the top surface of the first conductive pattern 52 is the first metal element. When the oxide of the second metal exists between the first conductive pattern 52 and the second conductive pattern 72, connection resistance between the first conductive pattern 52 and the second conductive pattern 72 is less than connection resistance between the first conductive pattern 52 and the second conductive pattern 72 when the oxide of the first metal exists between the first conductive pattern 52 and the second conductive pattern 72. The chip formed through integration has lower resistivity.

### Example 2

A main difference between Example 2 and Example 1 lies in that a first wiring layer 50 is not in contact with a transfer pattern 32, but is in contact with the transfer pattern 32 by using a transition wiring layer.

In some embodiments, as shown in FIG. 10A, a chip includes a substrate 10, an electronic element 20, an intermediate layer 30, at least one transition wiring layer, at least one inter-metal dielectric layer, a first inter-metal dielectric layer 40, a first wiring layer 50, a second inter-metal dielectric layer 60, and a second wiring layer 70.

The electronic element 20 is disposed on the substrate 10, and the electronic element 20 includes a conductive portion 201. The intermediate layer 30 is disposed on the electronic element 20, and a transfer pattern 32 in the intermediate layer 30 is in contact with the conductive portion 201.

The transition wiring layer is in contact with the transfer pattern 32. When the chip includes a plurality of transition wiring layers, the plurality of transition wiring layers are disposed in a stacked manner, and an outer side of the transition wiring layer is wrapped with the inter-metal dielectric layer.

A structure of the transition wiring layer may be similar to a structure of the first wiring layer 50 in Example 1, or may be similar to a structure of the second wiring layer 70 in Example 1. In FIG. 10A, an example in which the chip includes one transition wiring layer, and the structure of the transition wiring layer is similar to the structure of the first wiring layer 50 in Example 1 is used for illustration.

Structures of the first inter-metal dielectric layer 40, the first wiring layer 50, the second inter-metal dielectric layer 60, and the second wiring layer 70 are the same as those in Example 1. For details, refer to related descriptions in Example 1.

In some other embodiments, as shown in FIG. 10B, in addition to a first impervious pattern 51 and a first conductive pattern 52, a first wiring layer 50 further includes a fourth conductive pattern 53. The fourth conductive pattern 53 covers at least a bottom surface that is of the first impervious pattern 51 (or the first conductive pattern 52) and that is close to a substrate 10. In FIG. 10B, an example in which the fourth conductive pattern 53 covers the bottom surface and a side surface of the first impervious pattern 51 is used for illustration.

In other words, in this example, a structure of the first wiring layer 50 is similar to a structure of a second wiring layer 70, and preparation methods of the first wiring layer 50 and the second wiring layer 70 are also similar. In this way, metal oxide on a surface of a transition wiring layer is also reduced to a metal element, so that resistance of a chip can be reduced.

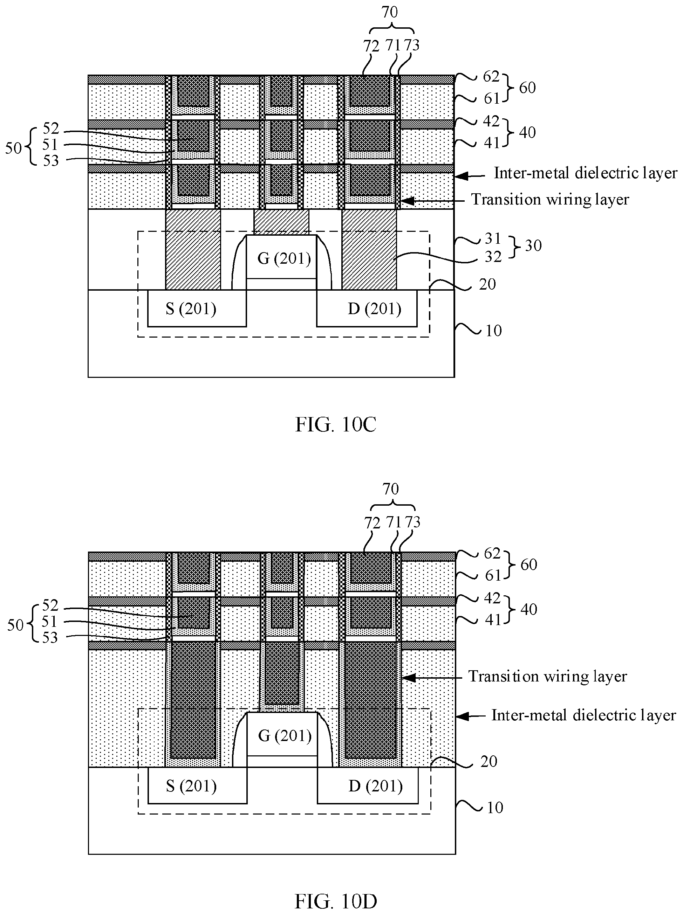

Similarly, a structure of the transition wiring layer may be similar to a structure of the first wiring layer 50 in Example 1. As shown in FIG. 10C, a structure of a transition wiring layer may alternatively be similar to a structure of the first wiring layer 50 in embodiments.

In still some other embodiments, as shown in FIG. 10D, a chip does not include an intermediate layer. A first wiring layer 50 is directly formed on a surface of an electronic element 20. Alternatively, a transition wiring layer is directly formed on a surface of an electronic element 20.

The foregoing descriptions are merely specific implementations of this application, but are not intended to limit the protection scope of this application as defined in the claims.

## Claims

1. A chip, comprising:
a substrate (10);
an electronic element (20) disposed on the substrate (10), wherein the electronic element (20) comprises a conductive portion (201);
a first wiring layer (50) disposed on a side that is of the electronic element (20) and that is away from the substrate (10), wherein the first wiring layer (50) comprises a first conductive pattern (52), and the first conductive pattern (52) is coupled to the conductive portion (201); and
a second wiring layer (70) disposed on a surface of the first wiring layer (50), wherein the second wiring layer (70) comprises a second conductive pattern (72) and a third conductive pattern (73), the third conductive pattern (73) comprises a first portion (731) disposed between the second conductive pattern (72) and the first conductive pattern (52), and the first portion (731) is in contact with the first conductive pattern (52) and is coupled to the second conductive pattern (72), wherein
a material of a top surface that is of the first conductive pattern (52) and that is in contact with the third conductive pattern (73) comprises a first metal element, a material of the first portion (731) comprises oxide of second metal, the oxide of the second metal is a conductive material, and reactivity of the second metal is greater than reactivity of the first metal,
wherein the third conductive pattern (73) further comprises a second portion (732) disposed on a side surface of the second conductive pattern (72),
**characterized in that**
a thickness of the first portion (731) is greater than a thickness of the second portion (732).

2. The chip according to claim 1, wherein a material of the second portion (732) comprises the second metal.

3. The chip according to claim 1 or 2, wherein the first metal is copper and the second metal is ruthenium, iridium or rhodium.

4. The chip according to any one of claims 1 to 3, wherein the material of the first portion (731) comprises, in addition to the oxide of the second metal, the second metal in unoxidized form.

5. The chip according to any one of claims 1 to 4, wherein a material of the first conductive pattern (52) is the first metal.

6. The chip according to any one of claims 1 to 5, wherein the first wiring layer (50) further comprises a fourth conductive pattern (53), and the fourth conductive pattern (53) covers at least a bottom surface of the first conductive pattern (52).

7. The chip according to any one of claims 1 to 6, wherein the electronic element (20) comprises at least one of a transistor, a capacitor, a resistor, or an inductor.

8. The chip according to any one of claims 1 to 5, wherein the first wiring layer (50) further comprises a first diffusion barrier pattern (51), and the first diffusion barrier pattern (51) covers a side surface and a bottom surface of the first conductive pattern (52).

9. The chip according to any one of claims 1 to 7, wherein the second wiring layer (70) further comprises a second diffusion barrier pattern (71), and the second diffusion barrier pattern (71) is disposed between the second conductive pattern (72) and the third conductive pattern (73) and covers a bottom surface and a side surface of the second conductive pattern (72).

10. A chip preparation method, comprising:
forming (S30, S40)) a first inter-metal dielectric layer (40) having a first opening (401) and a first wiring layer (50) on a substrate (10) on which an electronic element (20) is formed, wherein the first wiring layer (50) comprises a first conductive pattern (52), the first conductive pattern (52) passes through the first opening (401) and is coupled to a conductive portion (201) of the electronic element (20), and a material of the first conductive pattern (52) comprises first metal;
forming (S50) a second inter-metal dielectric layer (60) having a second opening (601) on the first inter-metal dielectric layer (40), wherein the second opening (601) exposes the first conductive pattern (52), and the first metal on a top surface of the first conductive pattern (52) is oxidized into oxide of the first metal;
forming (S61) a first metal film (730) on the first inter-metal dielectric layer (40), wherein the first metal film (730) is in contact with the top surface of the first conductive pattern (52) through the second opening (601), a material of the first metal film (730) comprises second metal, oxide of the second metal is a conductive material, and reactivity of the second metal is greater than reactivity of the first metal;
enabling (S62) the second metal to react with the oxide of the first metal, to reduce at least a part of the oxide of the first metal on the top surface of the first conductive pattern (52) to the first metal, and oxidize at least a part of the second metal in a portion that is of the first metal film (730) and that is in contact with the first conductive pattern (52) into the oxide of the second metal;
forming (S64) a second metal film (720) on the first metal film (730), wherein the second metal film (720) fills the second opening (601) and is coupled to the first conductive pattern (52); and
patterning (S60) the first metal film (730) and the second metal film (720), to form a third conductive pattern (73) and a second conductive pattern (72), so that a second wiring layer (70) is formed, wherein the third conductive pattern (73) comprises a first portion (731) disposed between the second conductive pattern (72) and the first conductive pattern (52), and a material of the first portion (731) comprises the oxide of the second metal.

11. The chip preparation method according to claim 10, wherein the third conductive pattern (73) further comprises a second portion (732) disposed on a side surface of the second conductive pattern (72),
wherein a thickness of the first portion (731) is greater than a thickness of the second portion (732).

12. The chip preparation method according to claim 10, wherein the forming (S61) the first metal film (730) on the first inter-metal dielectric layer (40) comprises:
forming the first metal film (730) on the first inter-metal dielectric layer (40) by using an atomic layer deposition process, wherein thicknesses of all portions of the first metal film (730) are equal, and a surface of the first metal film (730) is planar; or
forming the first metal film (730) on the first inter-metal dielectric layer (40) by using a physical vapor deposition process, wherein thicknesses of all portions of the first metal film (730) are equal, and a surface of the first metal film (730) is a curved surface; or
forming the first metal film (730) on the first inter-metal dielectric layer (40) by using a physical vapor deposition process at a very high frequency, wherein a thickness of a portion that is of the first metal film (730) and that is in contact with the top surface of the first conductive pattern (52) is greater than a thickness of a portion that is of the first metal film (730) and that is in contact with an inner wall of the second opening (601).

13. The chip preparation method according to any one of claims 10 to 12, wherein the enabling (S62) the second metal to react with the oxide of the first metal comprises:
performing (S70) annealing on the first conductive pattern (52) and the first metal film (730) at a temperature of 300°C to 400°C, so that an oxidation-reduction reaction occurs between the second metal in the first metal film (730) and the oxide of the first metal on the top surface of the first conductive pattern (52).

14. The chip preparation method according to any one of claims 10 to 13, wherein after the second wiring layer (70) is formed, the chip preparation method further comprises:
performing (S70), at the temperature of 300°C to 400°C in a gas environment comprising hydrogen, annealing on the substrate (10) on which the first wiring layer (50) and the second wiring layer (70) are formed.

15. An electronic device (1), comprising a circuit board and the chip according to any one of claims 1 to 9, wherein the chip is disposed on the circuit board.

## Patentansprüche

1. Chip, der Folgendes umfasst:
ein Substrat (10);
ein elektronisches Element (20), das auf dem Substrat (10) angeordnet ist, wobei das elektronische Element (20) einen leitfähigen Abschnitt (201) umfasst;
eine erste Verdrahtungsschicht (50), die auf einer Seite angeordnet ist, die zu dem elektronischen Element (20) gehört und die von dem Substrat (10) abgewandt ist, wobei die erste Verdrahtungsschicht (50) ein erstes leitfähiges Muster (52) umfasst und das erste leitfähige Muster (52) mit dem leitfähigen Abschnitt (201) gekoppelt ist; und
eine zweite Verdrahtungsschicht (70), die auf einer Oberfläche der ersten Verdrahtungsschicht (50) angeordnet ist, wobei die zweite Verdrahtungsschicht (70) ein zweites leitfähiges Muster (72) und ein drittes leitfähiges Muster (73) umfasst, das dritte leitfähige Muster (73) einen ersten Abschnitt (731) umfasst, der zwischen dem zweiten leitfähigen Muster (72) und dem ersten leitfähigen Muster (52) angeordnet ist, und der erste Abschnitt (731) mit dem ersten leitfähigen Muster (52) in Kontakt steht und mit dem zweiten leitfähigen Muster (72) gekoppelt ist, wobei
ein Material einer oberen Oberfläche, die zu dem ersten leitfähigen Muster (52) gehört und die mit dem dritten leitfähigen Muster (73) in Kontakt steht, ein erstes Metallelement umfasst, ein Material des ersten Abschnitts (731) ein Oxid eines zweiten Metalls umfasst, das Oxid des zweiten Metalls ein leitfähiges Material ist und die Reaktivität des zweiten Metalls größer als die Reaktivität des ersten Metalls ist,
wobei das dritte leitfähige Muster (73) ferner einen zweiten Abschnitt (732) umfasst, der auf einer Seitenoberfläche des zweiten leitfähigen Musters (72) angeordnet ist,
**dadurch gekennzeichnet, dass**
eine Dicke des ersten Abschnitts (731) größer als eine Dicke des zweiten Abschnitts (732) ist.

2. Chip nach Anspruch 1, wobei ein Material des zweiten Abschnitts (732) das zweite Metall umfasst.

3. Chip nach Anspruch 1 oder 2, wobei das erste Metall Kupfer ist und das zweite Metall Ruthenium, Iridium oder Rhodium ist.

4. Chip nach einem der Ansprüche 1 bis 3, wobei das Material des ersten Abschnitts (731) zusätzlich zu dem Oxid des zweiten Metalls das zweite Metall in nicht oxidierter Form umfasst.

5. Chip nach einem der Ansprüche 1 bis 4, wobei ein Material des ersten leitfähigen Musters (52) das erste Metall ist.

6. Chip nach einem der Ansprüche 1 bis 5, wobei die erste Verdrahtungsschicht (50) ferner ein viertes leitfähiges Muster (53) umfasst und das vierte leitfähige Muster (53) mindestens eine untere Oberfläche des ersten leitfähigen Musters (52) bedeckt.

7. Chip nach einem der Ansprüche 1 bis 6, wobei das elektronische Element (20) einen Transistor und/oder einen Kondensator und/oder einen Widerstand und/oder eine Induktivität umfasst.

8. Chip nach einem der Ansprüche 1 bis 5, wobei die erste Verdrahtungsschicht (50) ferner ein erstes Diffusionsbarrieremuster (51) umfasst und das erste Diffusionsbarrieremuster (51) eine Seitenoberfläche und eine untere Oberfläche des ersten leitfähigen Musters (52) bedeckt.

9. Chip nach einem der Ansprüche 1 bis 7, wobei die zweite Verdrahtungsschicht (70) ferner ein zweites Diffusionsbarrieremuster (71) umfasst und das zweite Diffusionsbarrieremuster (71) zwischen dem zweiten leitfähigen Muster (72) und dem dritten leitfähigen Muster (73) angeordnet ist und eine untere Oberfläche und eine Seitenoberfläche des zweiten leitfähigen Musters (72) bedeckt.

10. Verfahren zur Herstellung eines Chips, das Folgendes umfasst:
Bilden (S30, S40) einer ersten dielektrischen Zwischenmetallschicht (40) mit einer ersten Öffnung (401) und einer ersten Verdrahtungsschicht (50) auf einem Substrat (10), auf dem ein elektronisches Element (20) gebildet ist, wobei die erste Verdrahtungsschicht (50) ein erstes leitfähiges Muster (52) umfasst, das erste leitfähige Muster (52) durch die erste Öffnung (401) verläuft und mit einem leitfähigen Abschnitt (201) des elektronischen Elements (20) gekoppelt ist und ein Material des ersten leitfähigen Musters (52) ein erstes Metall umfasst;
Bilden (S50) einer zweiten dielektrischen Zwischenmetallschicht (60) mit einer zweiten Öffnung (601) auf der ersten dielektrischen Zwischenmetallschicht (40), wobei die zweite Öffnung (601) das erste leitfähige Muster (52) freilegt und das erste Metall auf einer oberen Oberfläche des ersten leitfähigen Musters (52) zu einem Oxid des ersten Metalls oxidiert wird;
Bilden (S61) eines ersten Metallfilms (730) auf der ersten dielektrischen Zwischenmetallschicht (40), wobei der erste Metallfilm (730) über die zweite Öffnung (601) mit der oberen Oberfläche des ersten leitfähigen Musters (52) in Kontakt steht, ein Material des ersten Metallfilms (730) ein zweites Metall umfasst, ein Oxid des zweiten Metalls ein leitfähiges Material ist und die Reaktivität des zweiten Metalls größer als die Reaktivität des ersten Metalls ist;
Ermöglichen (S62), dass das zweite Metall mit dem Oxid des ersten Metalls reagiert, um mindestens einen Teil des Oxids des ersten Metalls auf der oberen Oberfläche des ersten leitfähigen Musters (52) auf das erste Metall zu reduzieren, und Oxidieren mindestens eines Abschnitts des zweiten Metalls in einem Abschnitt, der zu dem ersten Metallfilm (730) gehört und der mit dem ersten leitfähigen Muster (52) in Kontakt steht, zu dem Oxid des zweiten Metalls;
Bilden (S64) eines zweiten Metallfilms (720) auf dem ersten Metallfilm (730), wobei der zweite Metallfilm (720) die zweite Öffnung (601) füllt und mit dem ersten leitfähigen Muster (52) gekoppelt ist; und
Strukturieren (S60) des ersten Metallfilms (730) und des zweiten Metallfilms (720), um ein drittes leitfähiges Muster (73) und ein zweites leitfähiges Muster (72) zu bilden, sodass eine zweite Verdrahtungsschicht (70) gebildet wird, wobei das dritte leitfähige Muster (73) einen ersten Abschnitt (731) umfasst, der zwischen dem zweiten leitfähigen Muster (72) und dem ersten leitfähigen Muster (52) angeordnet ist, und ein Material des ersten Abschnitts (731) das Oxid des zweiten Metalls umfasst.

11. Verfahren zur Herstellung eines Chips nach Anspruch 10, wobei das dritte leitfähige Muster (73) ferner einen zweiten Abschnitt (732) umfasst, der auf einer Seitenoberfläche des zweiten leitfähigen Musters (72) angeordnet ist,
wobei eine Dicke des ersten Abschnitts (731) größer als eine Dicke des zweiten Abschnitts (732) ist.

12. Verfahren zur Herstellung eines Chips nach Anspruch 10, wobei das Bilden (S61) des ersten Metallfilms (730) auf der ersten dielektrischen Zwischenmetallschicht (40) Folgendes umfasst:
Bilden des ersten Metallfilms (730) auf der ersten dielektrischen Zwischenmetallschicht (40) unter Verwendung eines Atomlagenabscheidungsprozesses, wobei Dicken aller Abschnitte des ersten Metallfilms (70) gleich sind und eine Oberfläche des ersten Metallfilms (730) planar ist; oder
Bilden des ersten Metallfilms (730) auf der ersten dielektrischen Zwischenmetallschicht (40) unter Verwendung eines Prozesses der physikalischen Gasphasenabscheidung, wobei Dicken aller Abschnitte des ersten Metallfilms (730) gleich sind und eine Oberflächen des ersten Metallfilms (730) eine gekrümmte Oberfläche ist; oder
Bilden des ersten Metallfilms (730) auf der ersten dielektrischen Zwischenmetallschicht (40) unter Verwendung eines Prozesses der physikalischen Gasphasenabscheidung bei einer sehr hohen Frequenz, wobei eine Dicke eines Abschnitts, der zu dem ersten Metallfilm (730) gehört und der mit der oberen Oberfläche des ersten leitfähigen Musters (52) in Kontakt steht, größer als eine Dicke eines Abschnitts ist, der zu dem ersten Metallfilm (730) gehört und der mit einer Innenwand der zweiten Öffnung (601) in Kontakt steht.

13. Verfahren zur Herstellung eines Chips nach einem der Ansprüche 10 bis 12, wobei das Ermöglichen (S62), dass das zweite Metall mit dem Oxid des ersten Metalls reagiert, Folgendes umfasst:
Durchführen (S70) von Tempern an dem ersten leitfähigen Muster (52) und dem ersten Metallfilm (730) bei einer Temperatur von 300 °C bis 400 °C, sodass es zu einer Oxidationsreduktionsreaktion zwischen dem zweiten Metall in dem ersten Metallfilm (730) und dem Oxid des ersten Metalls auf der oberen Oberfläche des ersten leitfähigen Musters (52) kommt.

14. Verfahren zur Herstellung eines Chips nach einem der Ansprüche 10 bis 13, wobei das Verfahren zur Herstellung eines Chips nach dem Bilden der zweiten Verdrahtungsschicht (70) ferner Folgendes umfasst:
Durchführen (70), bei einer Temperatur von 300 °C bis 400 °C in einer Wasserstoff umfassenden Gasumgebung, von Tempern an dem Substrat (10), auf dem die erste Verdrahtungsschicht (50) und die zweite Verdrahtungsschicht (70) gebildet sind.

15. Elektronische Vorrichtung (1), die eine Leiterplatte und den Chip nach einem der Ansprüche 1 bis 9 umfasst, wobei der Chip auf der Leiterplatte angeordnet ist.

## Revendications

1. Puce, comprenant :
un substrat (10) ;
un élément électronique (20) disposé sur le substrat (10), dans laquelle l'élément électronique (20) comprend une partie conductrice (201) ;
une première couche de câblage (50) disposée sur un côté qui est celui de l'élément électronique (20) et qui est éloigné du substrat (10), dans laquelle la première couche de câblage (50) comprend un premier motif conducteur (52), et le premier motif conducteur (52) est couplé à la partie conductrice (201) ; et
une deuxième couche de câblage (70) disposée sur une surface de la première couche de câblage (50), dans laquelle la deuxième couche de câblage (70) comprend un deuxième motif conducteur (72) et un troisième motif conducteur (73), le troisième motif conducteur (73) comprend une première partie (731) disposée entre le deuxième motif conducteur (72) et le premier motif conducteur (52), et la première partie (731) est en contact avec le premier motif conducteur (52) et est couplée au deuxième motif conducteur (72), dans laquelle
un matériau d'une surface supérieure qui est celle du premier motif conducteur (52) et qui est en contact avec le troisième motif conducteur (73) comprend un premier élément métallique, un matériau de la première partie (731) comprend un oxyde d'un deuxième métal, l'oxyde du deuxième métal est un matériau conducteur, et la réactivité du deuxième métal est supérieure à la réactivité du premier métal,
dans laquelle le troisième motif conducteur (73) comprend en outre une deuxième partie (732) disposée sur une surface latérale du deuxième motif conducteur (72),
**caractérisée en ce qu'**une épaisseur de la première partie (731) est supérieure à une épaisseur de la deuxième partie (732).

2. Puce selon la revendication 1, dans laquelle un matériau de la deuxième partie (732) comprend le deuxième métal.

3. Puce selon la revendication 1 ou 2, dans laquelle le premier métal est du cuivre et le deuxième métal est du ruthénium, de l'iridium ou du rhodium.

4. Puce selon l'une quelconque des revendications 1 à 3, dans laquelle le matériau de la première partie (731) comprend, en plus de l'oxyde du deuxième métal, le deuxième métal sous forme non oxydée.

5. Puce selon l'une quelconque des revendications 1 à 4, dans laquelle un matériau du premier motif conducteur (52) est le premier métal.

6. Puce selon l'une quelconque des revendications 1 à 5, dans laquelle la première couche de câblage (50) comprend en outre un quatrième motif conducteur (53), et le quatrième motif conducteur (53) couvre au moins une surface inférieure du premier motif conducteur (52).

7. Puce selon l'une quelconque des revendications 1 à 6, dans laquelle l'élément électronique (20) comprend au moins un élément parmi un transistor, un condensateur, une résistance ou un inducteur.

8. Puce selon l'une quelconque des revendications 1 à 5, dans laquelle la première couche de câblage (50) comprend en outre un premier motif de barrière de diffusion (51), et le premier motif de barrière de diffusion (51) couvre une surface latérale et une surface inférieure du premier motif conducteur (52).

9. Puce selon l'une quelconque des revendications 1 à 7, dans laquelle la deuxième couche de câblage (70) comprend en outre un deuxième motif de barrière de diffusion (71), et le deuxième motif de barrière de diffusion (71) est disposé entre le deuxième motif conducteur (72) et le troisième motif conducteur (73) et couvre une surface inférieure et une surface latérale du deuxième motif conducteur (72).

10. Procédé de préparation de puce, comprenant :
la formation (S30, S40) d'une première couche diélectrique intermétallique (40) ayant une première ouverture (401) et une première couche de câblage (50) sur un substrat (10) sur lequel un élément électronique (20) est formé, dans lequel la première couche de câblage (50) comprend un premier motif conducteur (52), le premier motif conducteur (52) traverse la première ouverture (401) et est couplé à une partie conductrice (201) de l'élément électronique (20), et un matériau du premier motif conducteur (52) comprend un premier métal ;
la formation (S50) d'une deuxième couche diélectrique intermétallique (60) ayant une deuxième ouverture (601) sur la première couche diélectrique intermétallique (40), dans lequel la deuxième ouverture (601) expose le premier motif conducteur (52), et le premier métal sur une surface supérieure du premier motif conducteur (52) est oxydé en oxyde du premier métal ;
la formation (S61) d'un premier film métallique (730) sur la première couche diélectrique intermétallique (40), dans lequel le premier film métallique (730) est en contact avec la surface supérieure du premier motif conducteur (52) à travers la deuxième ouverture (601), un matériau du premier film métallique (730) comprend un deuxième métal, un oxyde du deuxième métal est un matériau conducteur, et la réactivité du deuxième métal est supérieure à la réactivité du premier métal ;
l'activation (S62) du deuxième métal pour réagir avec l'oxyde du premier métal, pour réduire au moins une partie de l'oxyde du premier métal sur la surface supérieure du premier motif conducteur (52) sur le premier métal, et oxyder au moins une partie du deuxième métal dans une partie qui est celle du premier film métallique (730) et qui est en contact avec le premier motif conducteur (52) dans l'oxyde du deuxième métal ;
la formation (S64) d'un deuxième film métallique (720) sur le premier film métallique (730), dans lequel le deuxième film métallique (720) remplit la deuxième ouverture (601) et est couplé au premier motif conducteur (52) ; et
la structuration (S60) du premier film métallique (730) et du deuxième film métallique (720), pour former un troisième motif conducteur (73) et un deuxième motif conducteur (72), de sorte qu'une deuxième couche de câblage (70) est formée, dans lequel le troisième motif conducteur (73) comprend une première partie (731) disposée entre le deuxième motif conducteur (72) et le premier motif conducteur (52) et un matériau de la première partie (731) comprend l'oxyde du deuxième métal.

11. Procédé de préparation de puce selon la revendication 10, dans lequel le troisième motif conducteur (73) comprend en outre une deuxième partie (732) disposée sur une surface latérale du deuxième motif conducteur (72),
dans lequel une épaisseur de la première partie (731) est supérieure à une épaisseur de la deuxième partie (732).

12. Procédé de préparation de puce selon la revendication 10, dans lequel la formation (S61) du premier film métallique (730) sur la première couche diélectrique intermétallique (40) comprend :
la formation du premier film métallique (730) sur la première couche diélectrique intermétallique (40), en utilisant un processus de dépôt de couche atomique, dans lequel les épaisseurs de toutes les parties du premier film métallique (730) sont égales, et une surface du premier film métallique (730) est plane ; ou
la formation du premier film métallique (730) sur la première couche diélectrique intermétallique (40), en utilisant un processus de dépôt de vapeur physique, dans lequel les épaisseurs de toutes les parties du premier film métallique (730) sont égales, et une surface du premier film métallique (730) est une surface incurvée ; ou
la formation du premier film métallique (730) sur la première couche diélectrique intermétallique (40), en utilisant un processus de dépôt de vapeur physique à une très haute fréquence, dans lequel une épaisseur d'une partie qui est celle du premier film métallique (730) et qui est en contact avec la surface supérieure du premier motif conducteur (52) est supérieure à une épaisseur d'une partie qui est celle du premier film métallique (730) et qui est en contact avec une paroi interne de la deuxième ouverture (601).

13. Procédé de préparation de puce selon l'une quelconque des revendications 10 à 12, dans lequel l'activation (S62) du deuxième métal pour réagir avec l'oxyde du premier métal comprend :
l'exécution (S70) d'un recuit sur le premier motif conducteur (52) et le premier film métallique (730) à une température de 300 °C à 400 °C, de sorte qu'une réaction d'oxydo-réduction se produit entre le deuxième métal dans le premier film métallique (730) et l'oxyde du premier métal sur la surface supérieure du premier motif conducteur (52).

14. Procédé de préparation de puce selon l'une quelconque des revendications 10 à 13, dans lequel après la formation de la deuxième couche de câblage (70), le procédé de préparation de puce comprend en outre :
l'exécution (S70), à la température de 300 °C à 400 °C dans un environnement gazeux comprenant de l'hydrogène, d'un recuit sur le substrat (10) sur lequel la première couche de câblage (50) et la deuxième couche de câblage (70) sont formées.

15. Dispositif électronique (1), comprenant une carte de circuit imprimé et la puce selon l'une quelconque des revendications 1 à 9, dans lequel la puce est disposée sur la carte de circuit imprimé.
